(19)

Europäisches
Patentamt
European
Patent Office
Office européen
des brevets

(11) **EP 1 819 055 A1**

(12) **EUROPEAN PATENT APPLICATION**

(43) Date of publication:
**15.08.2007 Bulletin 2007/33**

(51) Int Cl.:
***H03M 13/11*** *(2006.01)*

(21) Application number: **07101974.9**

(22) Date of filing: **08.02.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **13.02.2006 JP 2006035019**

(71) Applicant: **Fujitsu Ltd.**
**Kawasaki-shi, Kanagawa 211-8588 (JP)**

(72) Inventors:
• **Ikeda, Norihiro**
**Kawasaki-shi**
**Kanagawa 211-8588 (JP)**
• **Miyazaki, Shunji**
**Kawasaki-shi**
**Kanagawa 211-8588 (JP)**

(74) Representative: **Stebbing, Timothy Charles**
**Haseltine Lake**
**Lincoln House**
**300 High Holborn**
**London WC1V 7JH (GB)**

(54) **Multi-rate low density parity check (LDPC) decoder and decoding method**

(57)     A decoding device for decoding data coded by a low density parity check (LDPC) code which can handle a plurality of code rates while the connections between memory (102,103) and edge-by-edge arithmetic units (110-1,110-2,...,110-Nc) remain the same regardless of the processing cycle or coding rate. The parity check matrices of all code rates have a uniform row weight. The decoder comprises a pattern storing unit storing information about the parity check matrix and the segmentation pattern of the parity check matrix, which is formed by segmenting the parity check matrix into a plurality of row groups and into a plurality of column groups. The likelihood information storing unit (102, 103) stores likelihood information of respective code bits of the coded data divided into each memory cell with respect to the respective column groups. The plurality of edge-by-edge arithmetic units (110-1,110-2,...110-Nc), each connected to memory cells storing the likelihood information about the column group, update the likelihood information based on the likelihood information stored in the connected memory cell.

*FIG. 1*

EP 1 819 055 A1

**Description**

The present invention relates to a decoding device and a decoding method that decode coded data by using a low density parity check (which will hereinafter be abbreviated to LDPC) code.

An error correcting code is applied to a communication system that transmits the data without any error, or a computer system etc that reads, without any error, the data saved on a magnetic disc, a compact disc, etc. This type of error correcting code is classified roughly into a block code and a convolutional code. The block code is defined as a method by which information data are divided into data blocks and a codeword is created from the data blocks. On the other hand, the convolutional code is defined as a method of coding the data in relation to other data blocks (e.g., the data blocks in the past).

LDPC code is a type of block code having a very high error correcting capability and exhibiting a characteristic close to a Shannon limit. LDPC code has already been utilized in the field of the magnetic discs etc, and will be, it is expected, applied to a next generation mobile communication system.

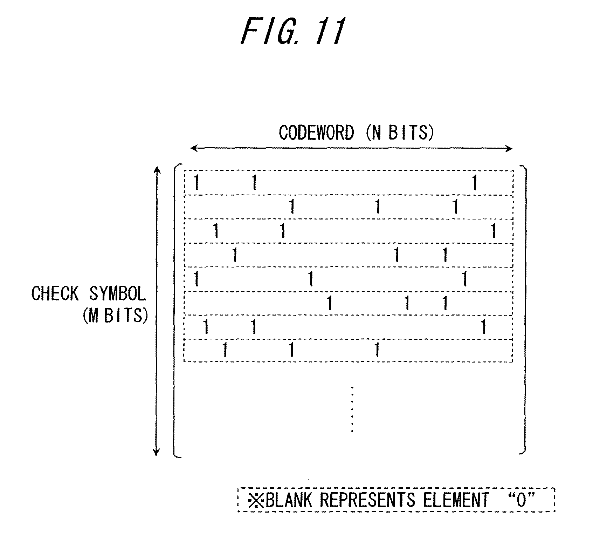

The LDPC code is generally defined by a parity check matrix (parity parity check matrix) in which matrix elements consist of "0" and "1", and the matrix elements "1" are sparsely allocated. Then, in the LDPC code, the parity check matrix is defined by (the number of check symbols (parity bit length) M x code length (code bit length) N) matrix (see FIG. 11).

LDPC codes include regular LDPC code and irregular LDPC code. Regular LDPC code employs a parity check matrix in which a weight (the number of "1"s in one row in the parity check matrix) $w_r$ of each row and a weight $w_c$ of each column are each fixed, and a relationship $w_c \ll N$ is established. Irregular LDPC code uses a parity check matrix in which the weight of each row and the weight of each column are not fixed. Irregular LDPC code is exemplified by an IRA (Irregular Repeat Accumulate) code, defined by the parity check matrix in which the weight $w_c$ of each column is not fixed while the weight $w_r$ of each row is fixed.

A decoding method of this type of LDPC code is an SPA (Sum-Product Algorithm). The SPA is an algorithm of reduced a calculation quantity but increased an error rate characteristic owing to such a feature of the LDPC code that the matrix elements of the parity check matrix contain a lesser number of "1"s. The SPA is an algorithm for outputting an estimated word on the basis of likelihood information (Log Likelihood Ratio (LLR)) of the codeword obtained by a check node process (row process) and a variable node process (column process). The SPA performs high-accuracy coding by repeating the check node process and the variable node process a predetermined number of times (the number of rounds).

An SPA-based decoding procedure will hereinafter be explained. It is to be noted that the following description might use an expression in the case of representing a parity check condition shown by the parity check matrix in the form of a Tanner graph (bipartite graph). Specifically, the matrix elements "1" of the parity check matrix are expressed as [edges], code bits corresponding to the respective columns in the parity check matrix are represented by [variable nodes], and check bits corresponding to the respective rows in the parity check matrix are represented by [check nodes] as the case may be.

At first, with respect to such a check node $s_j$ as to gain the elements $h_{ji}=1$ of the parity check matrix about all of the variable nodes $x_i$, the relative likelihood $q^{(0)}_{ij}(0)$ of the conditional anterior probability in the following Formula (1) is initialized (which will hereinafter be termed an initializing process). In the following Formula (1), $q^{(0)}_i(0)$ designates such a relative likelihood of the posterior probability as to establish $x_i=0$ of a round "0" and becomes the relative likelihood of the anterior probability for a reception signal.

[Mathematical Expression 1]

$$q^{(0)}{}_{ij}\left(0\right)=q^{(0)}{}_{i}\left(0\right) \qquad \dots \text{ Formula (1)}$$

Next, the check node process is executed. In connection with such variable nodes $x_i$ as to establish $h_{ji}=1$ about all of the check nodes $s_j$, the relative likelihood $r^{(u)}{}_{ji}(b)$ of the posterior probability is obtained in the following Formula (4). The relative likelihood $r^{(u)}{}_{ji}(b)$ of the posterior probability shown in the following Formula (4) represents the relative likelihood of the posterior probability that gains the check node $s_j=0$ under such a condition as to establish $x_i=b$ of a round $u$, $S_j$ represents an aggregation of $i$ of the variable nodes $x_i$ connected to the check nodes $s_j$, and $S_j\backslash i$ designates an aggregation of values obtained by subtracting $i$ from $S_j$.

[Mathematical Expression 2]

$$\alpha^{(u)}_{ij} = sign\left(q^{(u)}_{ij}(0)\right) \qquad ...Formula(2)$$

$$\beta^{(u)}_{ij} = \left|q^{(u)}_{ij}(0)\right| \qquad ...Formula(3)$$

$$r^{(u)}_{ji}(0) = \prod_{k \in S_j \backslash i} \alpha^{(u)}_{kj} \phi\left(\sum_{m \in S_j \backslash i} \phi\left(\beta^{(u)}_{mj}\right)\right) \qquad ...Formula(4)$$

$$sign(x) \equiv \begin{cases} 1, & x \geq 0 \\ -1, & x < 0 \end{cases}$$

$$\phi(x) = \log\left(\frac{e^x + 1}{e^x - 1}\right)$$

Next, variable node processing is executed. In connection with such a check node $s_j$ as to establish the elements $h_{ji}=1$ of the parity check matrix about all of the variable nodes $x_i$, the relative likelihood $q^{(u)}_{ij}(b)$ of the posterior probability is obtained in the Formula (5). In the formula (5), $X_i$ represents an aggregation of $j$ of the check nodes $s_j$ connected to the variable nodes $x_i$, and $X_i\backslash j$ designates an aggregation of values obtained by subtracting $j$ from $X_i$.

[Mathematical Expression 3]

$$q^{(u+1)}_i(0) = q^{(0)}_i(0) + \sum_{k \in X_i} r^{(u)}_{ki}(0) \qquad \text{... Formula (5)}$$

As described above, when the relative likelihood $q^{(u)}_{ij}(0)$ of the posterior probability about each variable node is obtained, a temporary estimated word (estimated bit sequence) is generated based on these piece of likelihood information as shown in the Formula (6).

[Mathematical Expression 4]

$$\hat{x}_i \equiv \begin{cases} 0, & q^{(u+1)}_i(0) \geq 0 \\ 1, & q^{(u+1)}_i(0) < 0 \end{cases} \qquad \text{... Formula (6)}$$

Then, the thus-obtained estimated bit sequence is subjected to a parity check. If the Formula (7) is satisfied, the estimated bit sequence is outputted. In the Formula (7), a suffix "T" represents transposition.

[Mathematical Expression 5]

$$\hat{x} \cdot H^T = 0 \qquad \text{... Formula (7)}$$

If the Formula (7) is not satisfied, there is performed an arithmetic operation shown in the Formula (8) for obtaining the relative likelihood $q^{(u+1)}_{ij}(b)$ of the conditional anterior probability for a next round (u + 1) (this process will hereinafter be referred to as an anterior variable node process).

[Mathematical Expression 6]

$$q^{(u+1)}{}_{ij}\left(0\right) = q^{(0)}{}_{ij}\left(0\right) + \sum_{k \in X_i \setminus j} r^{(u)}{}_{ki}\left(0\right)$$

$$= q^{(u+1)}{}_i\left(0\right) - r^{(u)}{}_{ji}\left(0\right) \qquad \dots \text{Formula (8)}$$

Hereafter, based on the relative likelihood $q^{(u+1)}{}_{ij}(b)$ of the conditional anterior probability acquired by this arithmetic operation, the check node process, the variable node process, the temporary estimation and the parity check in the round (u + 1) are carried out. A series of processes are terminated after the parity check has been satisfied or the processes have been executed a number of times corresponding to a predetermined maximum round count.

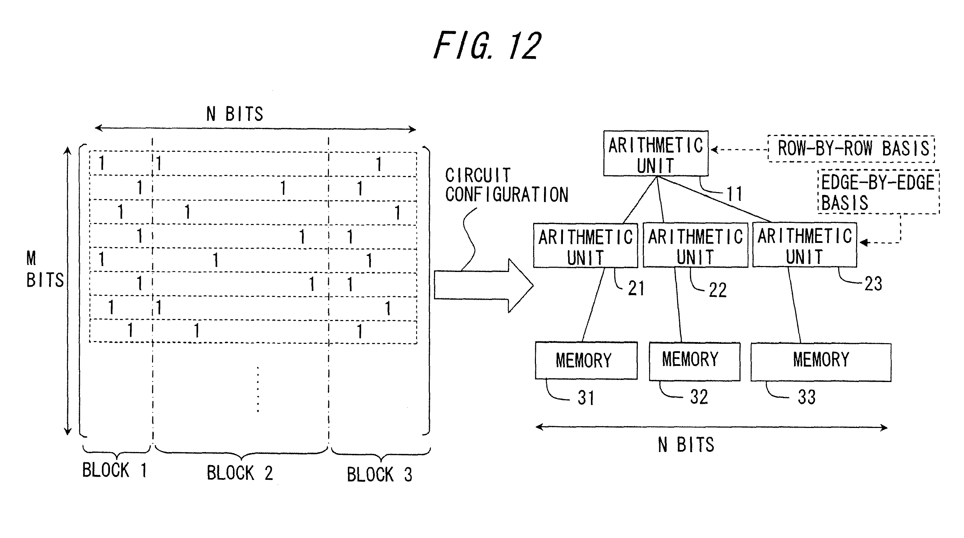

Next, a configuration of the conventional decoder using the SPA will be explained. In the case of dealing with such a code that the row weight is fixed as by the IRA etc, the decoder is configured to include arithmetic units corresponding to the row weight and to process the arithmetic operation in parallel on a row-by-row basis. Especially a mobile terminal performing mobile communications imposes limitations on circuit scale and therefore has a necessity of decreasing the number of arithmetic units used in the decoder to the greatest possible degree, and this configuration is adopted, thereby making it possible to increase availability efficiency of resources of the arithmetic unit and to speed up the decoding process. FIG. 12 is a diagram showing the configuration of the conventional preferable decoder corresponding to a predetermined parity check matrix, wherein the predetermined parity check matrix is illustrated on the left side, and the configuration of the conventional decoder corresponding to the parity check matrix is shown on the right side.

The parity check matrix shown in FIG. 12 is segmented into blocks each having one edge in every row within each of the blocks (blocks 1-3 in FIG. 12). In the decoder corresponding to this parity check matrix, arithmetic units (edge-by-edge arithmetic units 21, 22 and 23) are allocated one by one to the respective blocks in the parity check matrix in order to actualize parallel processing. Also provided is a row-by-row arithmetic unit 11 that executes batchwise the arithmetic operation on a row-by-row basis by using values calculated by the edge-by-edge arithmetic units 21, 22 and 23.

In the decoder having such a configuration, the edge-by-edge arithmetic units 21, 22 and 23 execute a check node process, a variable node process, an anterior variable node process, etc with respect to the edge existing in the processing target block on a check-node-by-check-node basis (on the row-by-row basis in the parity check matrix), and the row-by-row arithmetic unit 11 performs a necessary arithmetic operation (e.g., the Formula (4) etc) on the basis of the values calculated by the edge-by-edge arithmetic units 21, 22 and 23. This type of arithmetic operation on the check-node-by-check-node basis is carried out for all of the check nodes, whereby the temporary estimation and the parity check are, it follows, executed based on the finally-acquired likelihood information (posterior probability relative likelihood) of each variable node.

In the decoder adopting this configuration, further, it is required that a memory area storing the likelihood information of each variable node is connected to each arithmetic unit using the likelihood information of the variable node. This is because the likelihood information calculated in the previous round is used in each round. In the case of considering such a connection between the memory area and the arithmetic unit, normally a configuration is taken, wherein memory blocks 31, 32 and 33 in the parity check matrix are set corresponding to the respective blocks 1, 2 and 3, and pieces of likelihood information of the respective code bits belonging to the respective block are stored in the memory blocks 31, 32, and 33. The reason for this configuration is that it makes it possible to establish a one-to-one connection between the arithmetic unit and the memory and, accordingly, to simplify the circuit configuration.

It should be noted that a technology disclosed in the following documents is given as the conventional art related to the present invention of the present application. The conventional art document is "William E. Ryan, "An Introduction to LDPC Codes", "Department of Electrical and Computer Engineering, The University of Arizona", U.S.A., August 19 2003."

In the case of using the LDPC code in the field of mobile communications, however, an assumption is that a coding rate is changed corresponding to a propagation environment, and, in this case, it is required that the decoding process be executed using a different parity check matrix depending on every coding rate. In such a case, though it is conceivable to adopt a configuration providing a different decoder for every coding rate (each parity check matrix), it is not realistic in terms of the circuit scale to do this in the context of a mobile terminal for mobile communications.

Accordingly, there is a need for a decoder that can handle a plurality of coding rates. There is the following relationship between the coding rate and a size of the row weight and the parity check matrix.

High coding rate: Row weight is large, The number of rows in parity check matrix is small
Low coding rate: Row weight is small, The number of rows in parity check matrix is large

From this relationship, in the decoder corresponding to (i.e. handling) the plurality of coding rates, in the case of executing the arithmetic operation on the row-by-row basis, the processing time increases when executing the process at a low coding rate. Therefore, in the case of processing at the low coding rate, the processing time is required to be decreased by processing multiple rows simultaneously. Namely, it is necessary to consider the configuration of the decoder in a way that takes account of the difference in the number of the used arithmetic unit resources depending on the coding rate because of the row weight being different according to the coding rate. This entails abandoning the one-to-one connecting relationship between the arithmetic unit updating the likelihood information and the memory saving the likelihood information in the case of simultaneously processing the plurality of rows because of no relation between the respective rows in the parity check matrix.

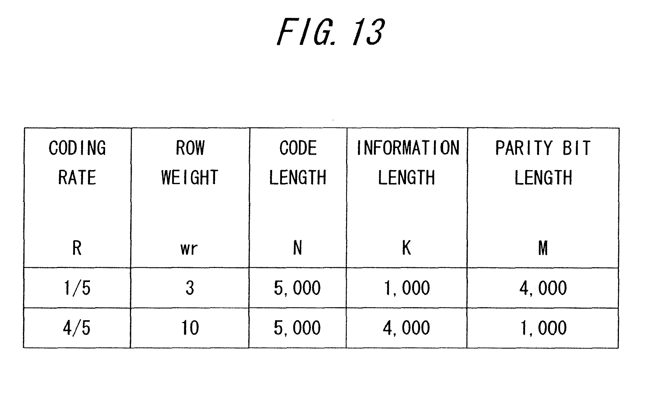

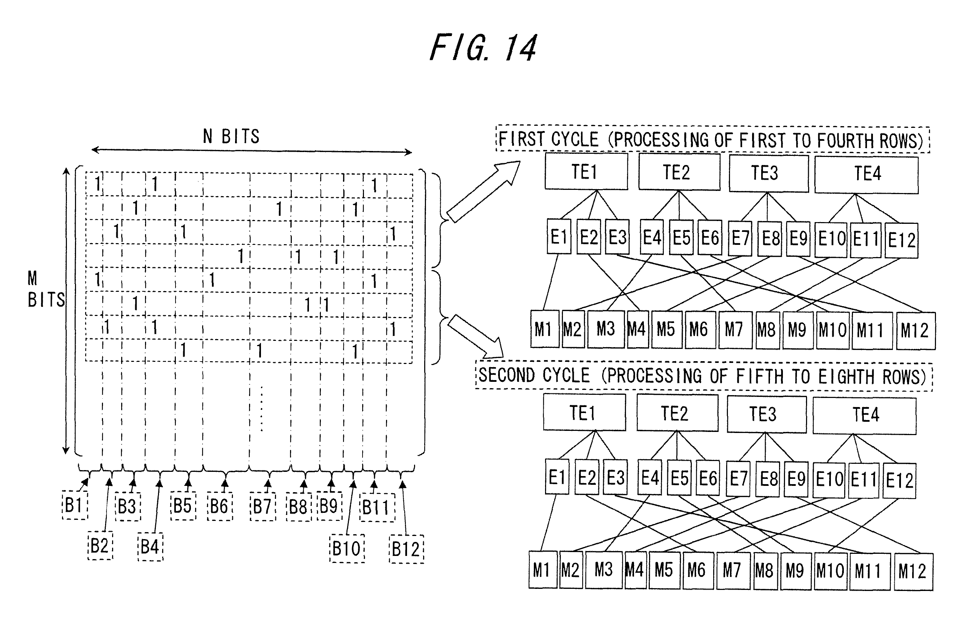

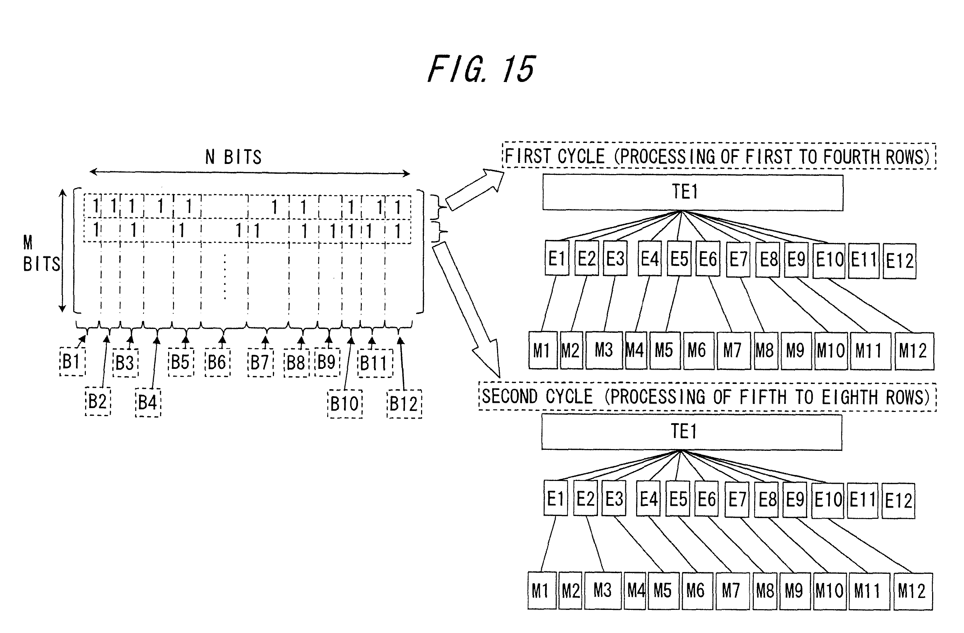

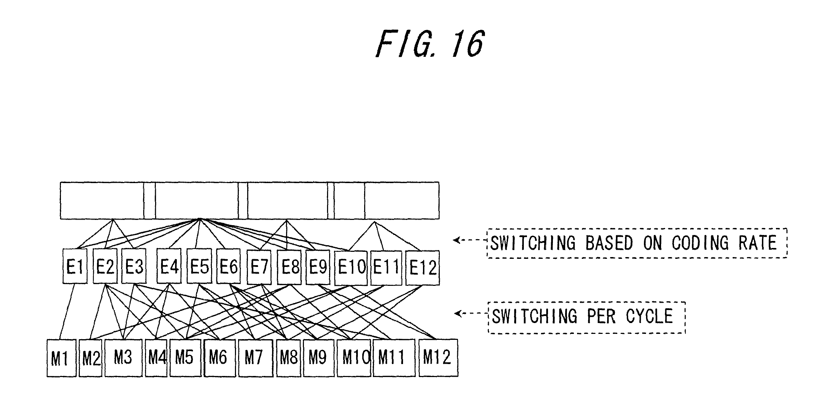

FIGS. 13 through 16 are diagrams each illustrating the configuration of the decoder corresponding to the plurality of coding rates, wherein specifically FIG. 13 illustrates a correspondence coding specification, FIG. 14 shows the parity check matrix and the configuration of the decoder in the case of corresponding to a low coding rate (R = 1/5), FIG. 15 shows the parity check matrix and the configuration of the decoder in the case of corresponding to a high coding rate (R = 4/5), and FIG. 16 shows the configuration of the decoder corresponding to a plurality of coding rates. The decoder illustrated in FIGS. 13 through 16 is configured so that the parity check matrix is segmented into 12 blocks (B1 - B12), and the respective arithmetic units (E1 - E12) process the arithmetic operations about the respective blocks.

In this configuration, when processing one row in the parity check matrix at one cycle while corresponding to the two coding rates shown in FIG. 13, all of the processes take 4000 cycles in the case of the low coding rate, and, by contrast, 1000 cycles suffice for all of the processes in the case of the high coding rate. Accordingly, the low coding rate needs an improved processing speed, and hence the configuration is attained so that, for instance, 4 rows are processed at one cycle (see FIG. 14). On the other hand, in the case of the high coding rate, the decoder is configured so that 1 row is processed at one cycle (see FIG. 15).

As a result, for decoder configurations in the case of the two coding rates in combination, there is a need to predefine a multi-to-multi connecting relationship between the arithmetic units (E1 - E12) and the memories (M1 - M12), and further the connection needs to be switched over corresponding to the coding rate and the processing cycle.

Thus, although the decoder corresponding to a single coding rate is simply constructed of arithmetic units and memories, the decoder corresponding to a plurality of coding rates additionally requires at least a circuit for switching over the connections between the memories and the arithmetic units, and therefore such a problem arises that the circuit scale increases. Moreover, this connection switching circuit takes a complicated circuit configuration due to the necessity of dynamically switching over the multi-to-multi connection between the memories and the arithmetic units.

It is therefore desirable to provide a decoding device that actualizes a high-speed decoding process while restraining the circuit scale.

The present invention adopts the following configurations. Namely, one aspect of the present invention provides a decoding device decoding coded data coded by a low density parity check code in a way that uses a plurality of parity check matrixes, corresponding to a plurality of coding rates, in which a row weight gets fixed, comprising a pattern storing means storing information about a parity check matrix, in the plurality of parity check matrixes, corresponding to the coding rate of the coded data and the segmentation pattern of the parity check matrix, which is formed by segmenting each of the plurality of parity check matrixes into a plurality of row groups and into a plurality of column groups of which the number is the same throughout the plurality of parity check matrixes, and by allocating each of the plurality of parity check matrixes so that there is one edge allocation area, which is a unit area of a plurality of segmented unit areas and has an edge, in each of the plurality of column groups within each of the plurality of row groups, a likelihood information storing means storing likelihood information of the respective code bits of the coded data in a way that divides the likelihood information of the respective code bits of the coded data into each memory cell with respect to each of the plurality of column groups based on the stored segmentation pattern, and a plurality of edge-by-edge arithmetic means each connected, corresponding to any one of the edge allocation areas, to the memory cell storing the likelihood information about the column group to which the corresponding edge allocation area belongs, and updating the likelihood information of the code bit corresponding to an edge within the corresponding edge allocation area based on the likelihood information stored in the connected memory cell.

In embodiments of the present invention, the predetermined segmentation pattern is defined with respect to each of the plurality of parity check matrixes corresponding to the plurality of coding rates. In this segmentation pattern, the respective parity check matrixes are segmented so that there exists the plurality of row groups each having the predetermined number of rows and further there exists the plurality of column groups each having the predetermined number of columns. In the plurality of unit areas each serving as a minimum unit after segmentation, the segmentation is done so that one edge allocable area where an edge is allocated exists in each column group within each row group. The thus-determined segmentation pattern and the thus-determined parity check matrix are generated for every coding rate, and the parity check matrix corresponding to the coded data defined as a decoding target data in these pieces of information and the segmentation pattern thereof, are stored. The decoding device according to the present invention is configured corresponding to the thus-determined parity check matrix and the thus-determined segmentation pattern.

Each of the memory cells is set corresponding to each of the column groups according to this segmentation pattern, and stores the likelihood information of the code bit corresponding to the column (variable node) contained in the corresponding column group.

Each of the edge-by-edge arithmetic units is set corresponding to any one edge allocation area, and is connected to the memory cell storing the likelihood information of the code bit corresponding to the column group to which this edge allocation area belongs. Each edge-by-edge arithmetic unit updates, with this configuration taken, the likelihood information of the code bit corresponding to the position of the edge within the corresponding edge allocation area based on the likelihood information in the connected memory cell.

Thus, each memory cell is set corresponding to each column group (variable node group), and the edge-by-edge arithmetic unit is set corresponding to the edge allocation area as an only-one existence in each column group within each row group, and therefore, the connection between each memory cell and each edge-by-edge arithmetic unit is resultantly actualized in a one-to-one relationship.

Accordingly, the decoding device corresponding to the plurality of coding rates has hitherto required the switch for switching over the complicated connection between the memory cell and the arithmetic unit, however, by means of the present invention, it is possible to omit this type of switch and, more essentially, to scale down the circuit of the decoding device.

Further, the plurality of edge-by-edge arithmetic units is provided and is set corresponding to the respective edge allocation areas, and hence it is feasible to execute the parallel processing of the edge-by-edge arithmetic operations and also to execute the high-speed decoding process.

Moreover, in the decoding device according to the present invention, the pattern storing means may store a position of the edge allocation area and a position of the edge within the edge allocation area, as information about each parity check matrix, and each of the edge-by-edge arithmetic means may determine an address of the should-be-updated likelihood information within the connected memory cell based on the stored edge position with respect to a processing target edge allocation area.

By using the present invention, it may be sufficient to retain the bare minimum of information (about the position of the edge allocation area and the position of the edge within the edge allocation area) based on the segmentation pattern without retaining all the information with respect to each of the parity check matrixes, thereby making it possible to restrain a memory capacity etc and to reduce the scale of the circuit.

Furthermore, each row group may be an aggregation of the rows subjected to a decoding process at one processing cycle, and the plurality of edge-by-edge arithmetic means may be provided, of which the number corresponds to at least a numerical value obtained by multiplying a row count of the rows undergoing the decoding process at one processing cycle by the row weight of the parity check matrix, and may update the likelihood information for the single row group at one processing cycle.

The use of a concept of the row group subjected to simultaneous processing at one processing cycle, makes it feasible to uniquely determine the connection between every edge-by-edge arithmetic unit and every memory cell at any processing cycle and at any coding rate with respect to the plurality of parity check matrixes corresponding to the plurality of coding rates.

Further, each parity check matrix and the segmentation pattern may have such allocation that each unit area is formed of at least one matrix, any one of the matrixes contained in the edge allocation areas becomes an edge allocation matrix where the edge is allocated, and other matrixes become zero matrixes, the pattern storing means may store, as the information on each parity check matrix, a position of the edge allocation area, a position of the edge allocation matrix in the edge allocation area and a position of the edge within the edge allocation matrix, and each of the edge-by-edge arithmetic means may determine the address of the should-be-updated likelihood information within the connected memory cell based on the position of the edge allocation matrix related to the processing target edge allocation area and the position of the edge within the edge allocation matrix.

Preferably, each square matrix is segmented to have the plurality of rows and the plurality of columns, and further this segmentation uses the matrix taking a predetermined shape.

In this way, the number of the row groups themselves can be reduced simply by having, as the information about the parity check matrix, the position of the edge allocation area, the position of the edge allocation matrix within this edge allocation area and the position of the edge within the edge allocation matrix, and hence the should-be-stored information can be decreased owing to the information about the parity check matrix on the whole. It is therefore possible to further restrain the memory capacity.

Moreover, the matrix contained in each unit area may be a square matrix.

With this contrivance, the information needed in terms of recognizing the shape of the matrix contained in the unit area can be reduced, and hence the amount of information to be stored can be also decreased owing to the information about the parity check matrix.

Furthermore, each unit area may be one matrix, the edge may be allocated in the respective rows in the edge allocation area, the pattern storing means may store, as information about each parity check matrix, a position of the edge allocation area, a shape of the matrix in the edge allocation area, and a position of the edge within the edge allocation area, and each of the edge-by-edge arithmetic means may determine the address of the should-be-updated likelihood information within the connected memory cell based on the shape of the matrix in the edge allocation area related to the processing target edge allocation area and the position of the edge in the edge allocation area.

In embodiments of the present invention, the unit area can be formed in an arbitrary shape, and therefore a degree of freedom in terms of determining the parity check matrix can be increased, whereby the matrix having high error correcting capability as the LDPC code can be selected.

Further, each parity check matrix may be a parity check matrix in which to rearrange the columns and/or the rows of the real parity check matrix corresponding to the coded data, and the likelihood information storing means may rearrange, based on rearrangement information from the real parity check matrix into the stored parity check matrix, the likelihood information of the code bits of the coded data in accordance with the stored parity check matrix, may thereafter divide the likelihood information into the respective memory cells per column group based on the stored segmentation pattern, and may store the divided likelihood information.

As mentioned above, the parity check matrix in which to rearrange the columns and/or the rows of the real parity check matrix that should be actually used for decoding, is used. Then, for corresponding to the rearrangement, the process is executed after rearranging pieces of likelihood information of the respective code bits of the coded data in accordance with the parity check matrix.

Hence, it is possible to deal with a case where the real parity check matrix does not match with the segmentation pattern of the present invention, and it is therefore possible to determine the parity check matrix having the high degree of freedom taking into consideration the error correcting capability of the LDPC code.

It should be noted that the present invention may also be embodied in a program that allows a computer to perform any one of the functions actualized. Moreover, the present invention may also be provided in the form of a readable-by-computer storage medium storing such a program.

Embodiments of the present invention make it feasible to provide a decoding device that actualizes the high-speed decoding process while restraining the circuit scale. Reference is made, by way of example only, to the accompanying drawings in which:

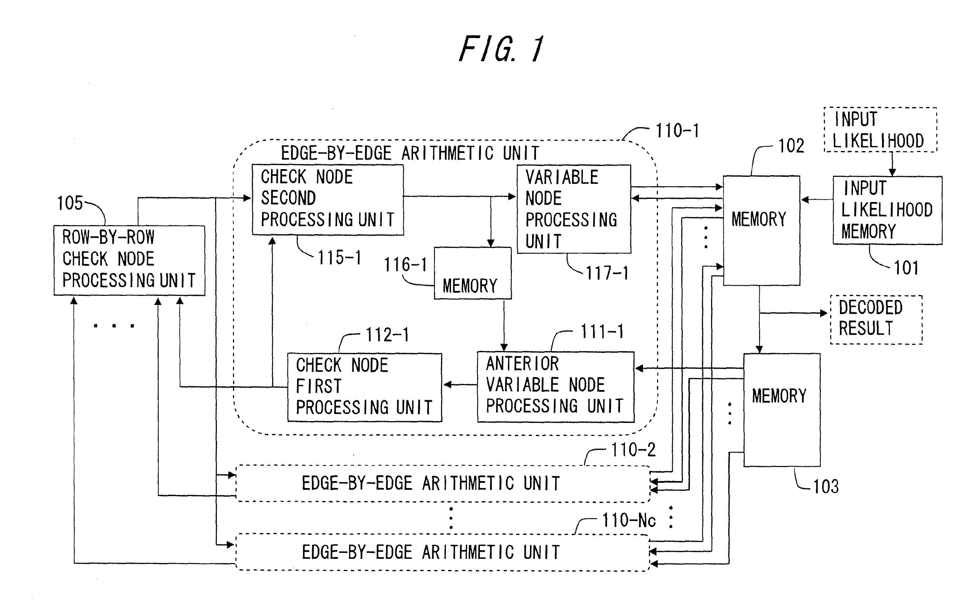

FIG. 1 is a diagram showing an example of a circuit configuration of a decoding device in a first embodiment;

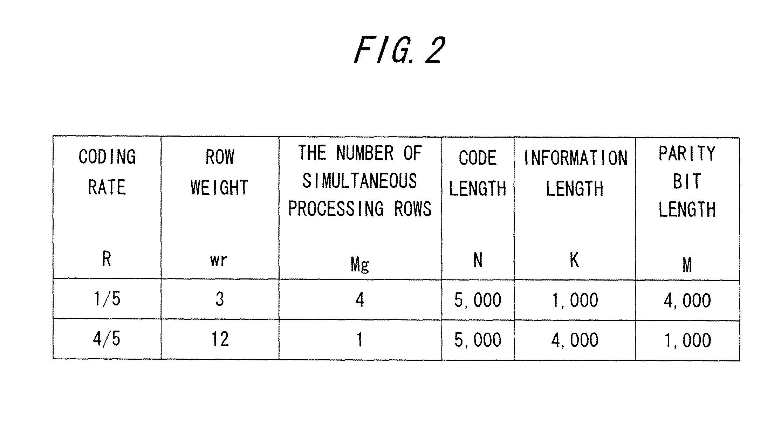

FIG. 2 is a diagram showing a coding specification in the first embodiment;

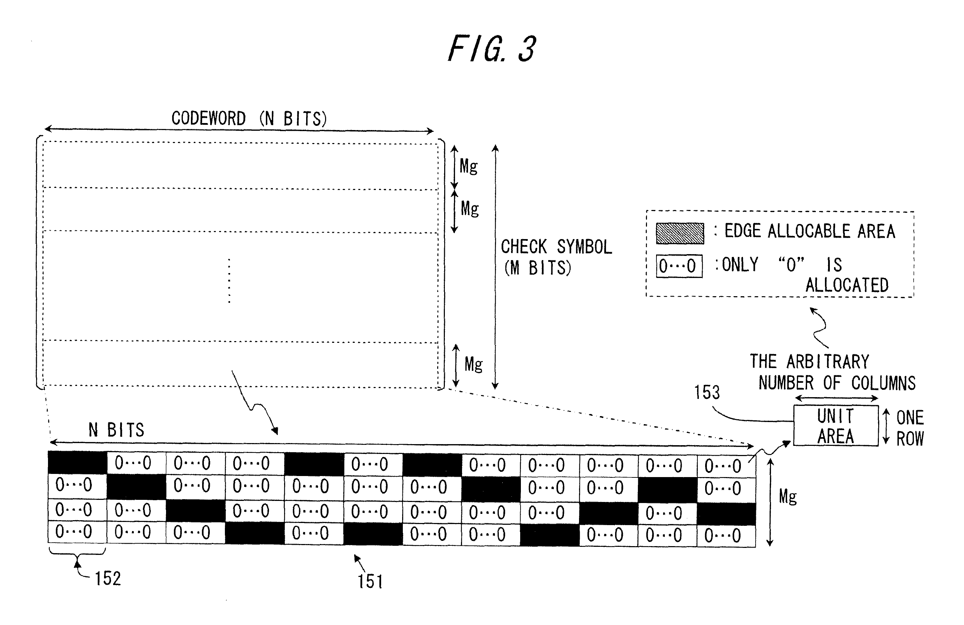

FIG. 3 is a diagram illustrating a parity check matrix in the first embodiment;

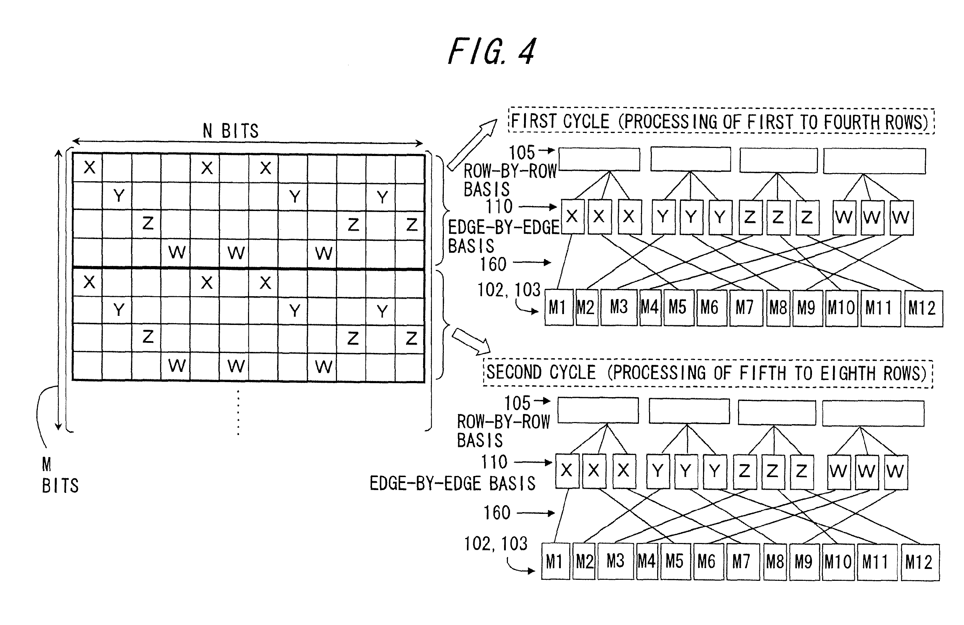

FIG. 4 is a diagram showing the connecting relationship between the arithmetic units and the memories at a coding rate 1/5 in the first embodiment;

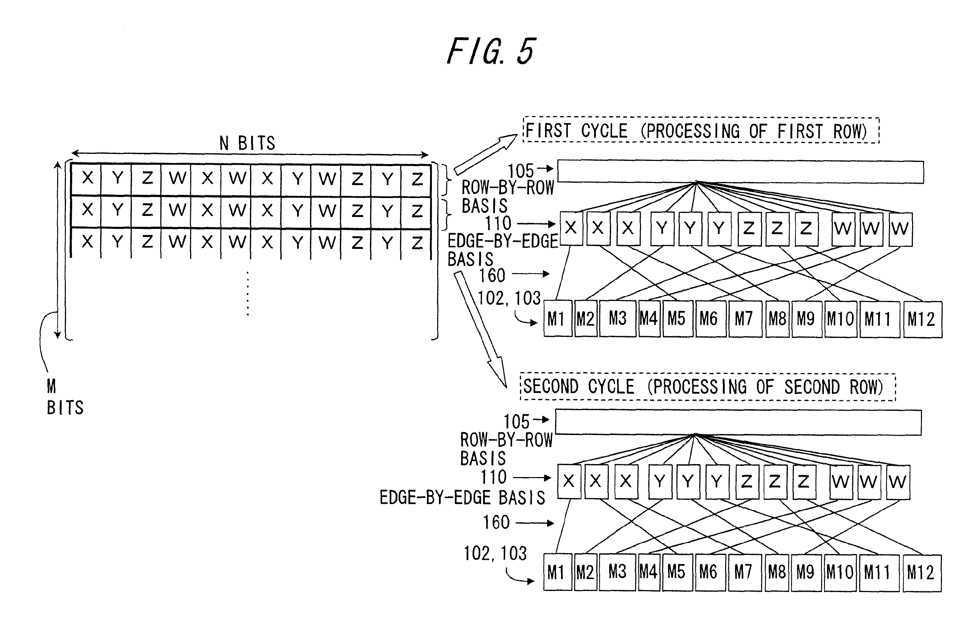

FIG. 5 is a diagram showing the connecting relationship between the arithmetic units and the memories at a coding rate 4/5 in the first embodiment;

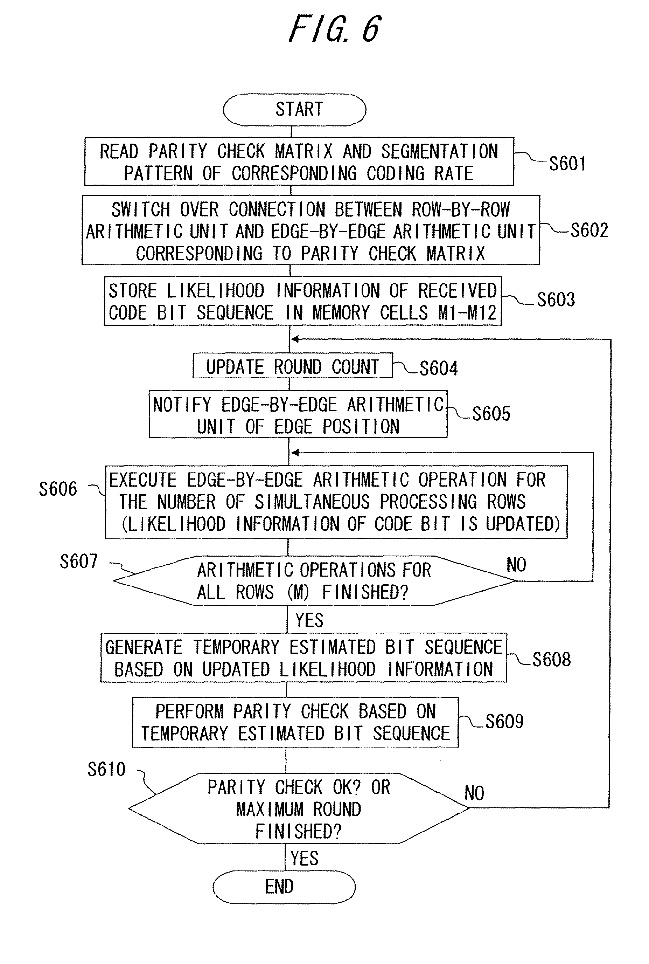

FIG. 6 is a flowchart showing an operational example of the decoding device in the first embodiment;

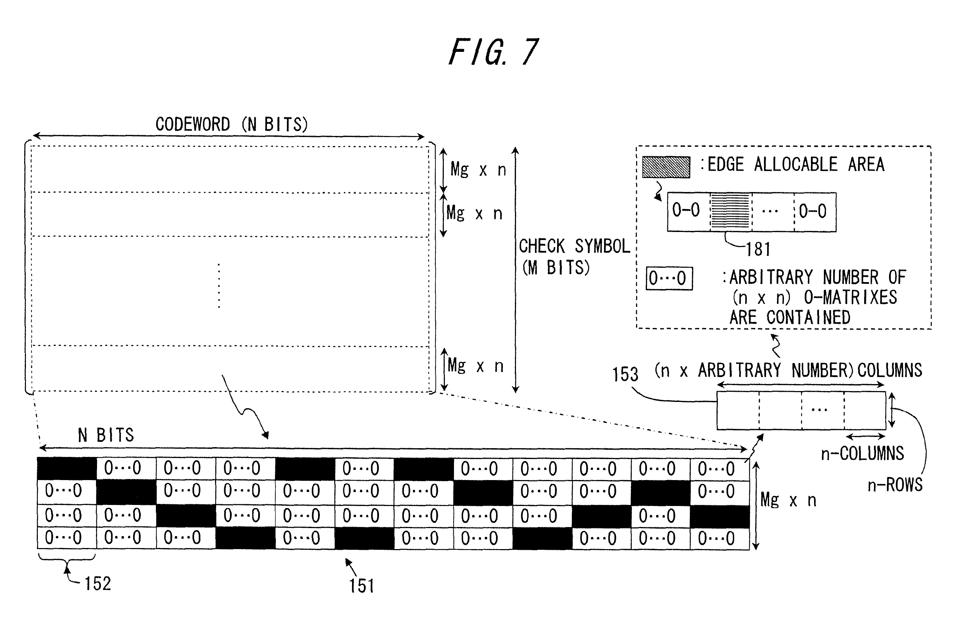

FIG. 7 is a diagram showing the parity check matrix in a second embodiment;

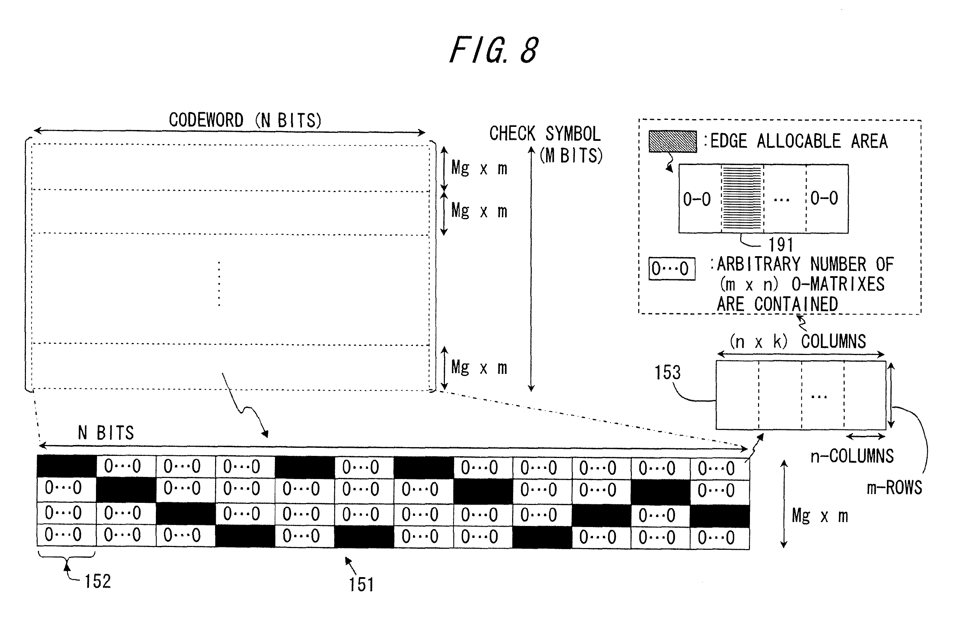

FIG. 8 is a diagram showing the parity check matrix in a third embodiment;

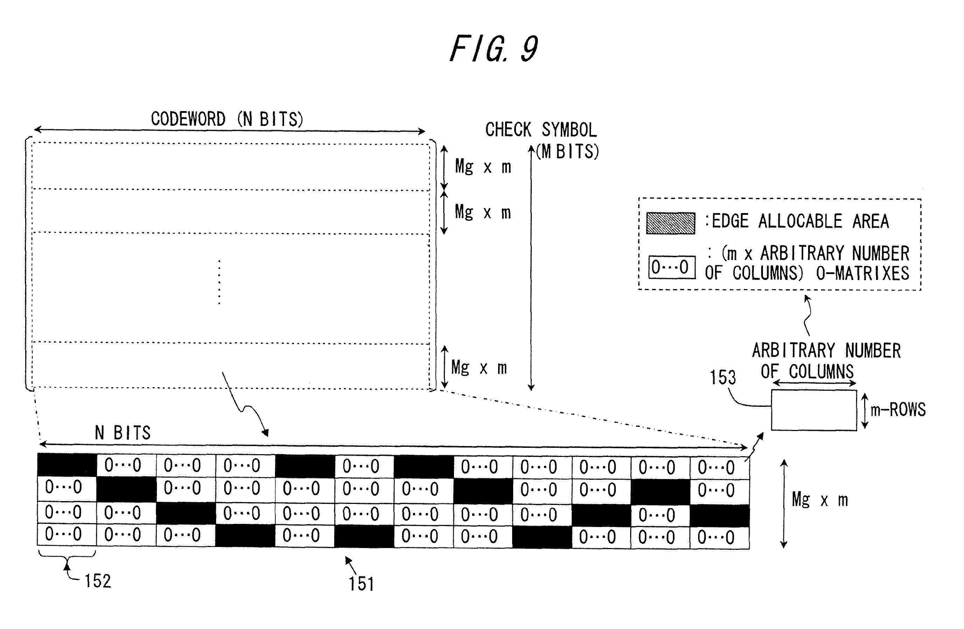

FIG. 9 is a diagram showing the parity check matrix in a fourth embodiment;

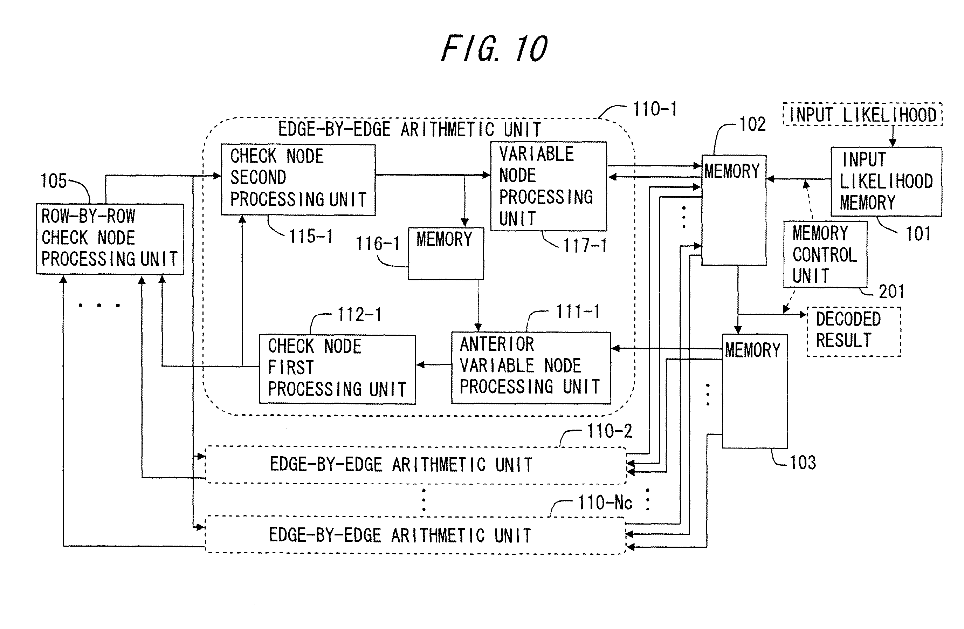

FIG.10 is a diagram showing an example of a circuit configuration of the decoding device in a fifth embodiment;
FIG.11 is a diagram showing the parity check matrix;
FIG.12 is a diagram showing a configuration of a conventional decoder;
FIG.13 is a diagram showing a correspondence coding specification;
FIG.14 is a diagram showing a configuration of the decoder corresponding to a plurality of coding rates when operating at the coding rate 1/5;
FIG.15 is a diagram showing a configuration of the decoder corresponding to the plurality of coding rates when operating at the coding rate 4/5; and
FIG.16 is a diagram showing a configuration of the decoder corresponding to the plurality of coding rates.

A decoding device in each of embodiments of the present invention will hereinafter be described with reference to the drawings. It should be noted that configurations in the embodiments, which will hereinafter be discussed, are exemplifications, and the present invention is not limited to the configurations in the following embodiments.

[First Embodiment]

The decoding device in a first embodiment of the present invention will hereinafter be explained.

[Device Configuration]

FIG. 1 is a block diagram showing the example of the circuit configuration of the decoding device in the first embodiment. The decoding device in the first embodiment includes an input likelihood memory 101, a $q^{(u+1)}{}_i$ memory 102 (which will hereinafter simply be termed the memory 102), a $q^{(u)}{}_i$ memory 103 (below, memory 103), row-by-row check node processing units 105 and edge-by-edge arithmetic units 110-1 to 110-Nc (corresponding to an edge-by-edge arithmetic means of the present invention). The reference symbols and numerals used in the following discussion are the same as those used in the introduction part of this specification.

The input likelihood memory 101 stores posterior probability relative likelihood (which will hereinafter simply be termed likelihood information ($q^{(0)}{}_i(0)$) calculated by another circuit with respect to each code bit of a received code bit sequence.

The memory 102 and the memory 103 stores the likelihood information $q^{(u+1)}{}_i$ and the likelihood information $q^{(u)}{}_i$ about each of the code bits. To be specific, the $q^{(u)}{}_i$ memory 103 stores the likelihood information that is referred to in a round u, i.e., the likelihood information calculated in the previous round, and the $q^{(u+1)}{}_i$ memory 102 stores the likelihood information calculated in the round u. Further, the memory 102 and the memory 103 are each constructed of a plurality of memory cells and each has a predetermined capacity. The likelihood information stored in each memory cell is determined in accordance with a parity check matrix. Moreover, a method of connecting each memory cell to each edge-by-edge arithmetic unit will be explained later on.

The row-by-row check node processing unit 105 receives a value given in the following formula (9), which is outputted from each of the edge-by-edge arithmetic units 110-1 to 110-Nc, and calculates a value given in the following Formula (10) about all of such variable nodes $x_i$ as to establish $h_{ji}=1$ with respect to the check nodes $s_j$. "$\alpha$" and "$\beta$" shown in the Formula (9) are based on the Formulae (2), (3) and (4).

[Mathematical Expression 7]

$$\alpha^{(u)}{}_{ij} \cdot \phi\left(\beta^{(u)}{}_{ij}\right) \qquad ...Formula(9)$$

$$\prod_{k \in S_j \setminus i} \alpha^{(u)}{}_{kj} \phi\left(\sum_{m \in S_j} \phi\left(\beta^{(u)}{}_{mj}\right)\right) \qquad ...Formula(10)$$

The edge-by-edge arithmetic units 110-1 to 110-Nc are provided on an edge-by-edge basis (block-by-block basis). The edge-by-edge arithmetic units 110-1 to 110-Nc execute parallel processing for every check node. The edge-by-edge arithmetic units 110-1 to 110-Nc each have the same configuration, and hence the edge-by-edge arithmetic unit 110-1 will be exemplified in the following description. The edge-by-edge arithmetic unit 110-1 includes an anterior variable node processing unit 111-1, a check node first processing unit 112-1, a check node second processing unit 115-1, an $r_{ji}$ memory 116-1 and a variable node processing unit 117-1.

The anterior variable node processing unit 111-1 executes the anterior variable node process described in the introduction with respect to a target edge (a first edge) of the check node $s_j$. Specifically, the anterior variable node processing unit 111-1 reads a piece of likelihood information $q^{(u)}{}_i(0)$ about the target edge of the check node $s_j$ from the $q^{(u)}{}_i$ memory 103, further reads a piece of likelihood information $r^{(u-1)}{}_{ji}(0)$ of the previous round of the check node $s_j$ from the $r_{ji}$ memory 116-1, and executes an arithmetic operation in the following Formula (11). The following Formula (11) corresponds to the above-mentioned Formula (8). The anterior variable node processing unit 111-1 calculates conditional anterior probability relative likelihood (which will hereinafter simply be termed anterior likelihood information) $q^{(u)}{}_{ij}(0)$ utilized in the round u. Note that when the round u = 0, the likelihood information $r^{(u-1)}{}_{ji}(0)$ of the previous round is not read out.

[Mathematical Expression 8]

$$q^{(u)}{}_{ij}(0) = q^{(u)}{}_i(0) - r^{(u-1)}{}_{ji}(0) \qquad \text{... Formula (11)}$$

The check node first processing unit 112-1, when receiving the anterior likelihood information form the anterior variable node processing unit 111-1, performs the arithmetic operations based on the Formulae (2), (3) and (4), thereby calculating the value shown in the Formula (9). The thus-calculated value is transferred to the row-by-row check node processing unit 105 and to the check node second processing unit 115-1.

The check node second processing unit 115-1, when receiving the value shown in the formula (10) from the row-by-row check node processing unit 105 and further receiving the value shown in the Formula (9) from the check node first processing unit 112-1, calculates the likelihood information $r^{(u)}{}_{ji}(0)$ shown in the Formula (4) with respect to the target edge of the check node $s_j$. The check node second processing unit 115-1, on the occasion of calculating this likelihood information, executes the arithmetic operation in the following Formula (12). The calculated likelihood information is transferred to the $r_{ji}$ memory 116-1 and to the variable node processing unit 117-1.

[Mathematical Expression 9]

$$ r^{(u)}{}_{ji}(0) = \prod_{k \in S_j} \alpha^{(u)}{}_{kj} \cdot \alpha^{(u)}{}_{ij} \cdot \phi\left( \sum_{m \in S_j} \phi\left(\beta^{(u)}{}_{mj}\right) - \phi\left(\beta^{(u)}{}_{ij}\right) \right) \quad \text{... Formula (12)} $$

The $r_{ji}$ memory 116-1 retains the likelihood information $r^{(u)}{}_{ji}(0)$ calculated in each round in order to be used in the anterior variable node process by the anterior variable node processing unit 111-1.

The variable node processing unit 117-1 performs the arithmetic operation of adding $r^{(u)}{}_{ji}(0)$ about the check node $s_j$ in the variable node process shown in the Formula (5), as described in the introduction. Namely, the variable node processing unit 117-1 reads pieces of likelihood information added up to a check node $s_{j-1}$ from the memory 102 and adds, to this readout likelihood information, the likelihood information $r^{(u)}{}_{ji}(0)$ calculated this time by the check node second processing unit 115-1. The added likelihood information is written again to the memory 102.

Parallel processing is executed for every check node $s_j$ by each of the functional units described above, and the process of each functional unit described above is repeated the number of times corresponding to the number of check nodes (M). Upon completion of the processes executed (M-1) times starting from the check node count "0", the memory 102 contains the likelihood information of the respective variable nodes. Then, the contents in the memory 102 are copied to the memory 103, while the contents in the input likelihood memory 101 are copied to the memory 102, and the process described above is repeated as a process of the next round. Note that a temporary estimation process and a parity check process (not shown) are executed upon completing the processes for all the check nodes, and, if a result of the check is correct, an estimated bit sequence at this time is outputted as a decoded result without executing the process of the next round.

<Parity check matrix>

Next, a parity check matrix used in the first embodiment will be explained with reference to FIGS. 2 and 3. FIG. 2 is a diagram showing a coding specification in the first embodiment. FIG. 3 is a diagram illustrating the parity check matrix used in the first embodiment.

To start with, before determining the parity check matrix used in the first embodiment, the coding specification carried out in the present decoding device is determined. The present decoding device at first determines corresponding coding rates in terms of determining the coding specification. In the first embodiment, as illustrated in FIG. 2, items of data correspond to a coding rate 1/5 and a coding rate 4/5, respectively. The present invention is not, however, limited to these coding rates.

Subsequently, the mounting count (Nc) of the arithmetic units is determined. The mounting count (Nc) of the arithmetic units means the number of the edge-by-edge arithmetic units (110-1 to 110-Nc). Then, a row weight (Wr) and the number of simultaneous processing rows (Mg) are determined based on this mounting count (Nc) of the arithmetic units with respect to each coding rate. At this time, the mounting count (Nc) of the arithmetic units, the row weight (Wr) and the number of the simultaneous processing rows (Mg) are respectively determined to establish a relationship such as (Nc) = (Wr) x (Mg). For instance, in the case of taking a higher coding rate in the plurality of corresponding coding rates, the row weight may be determined so that the number of the simultaneous processing rows becomes "1". The first embodiment exemplifies a case in which the coding specification as shown in FIG. 2 is determined.

When the coding specification is determined, the parity check matrix is determined corresponding to each coding rate on the basis of this coding specification. A size of each parity check matrix is determined from a parity bit length (M) and a code length (N) in the coding specification described above.

In the first embodiment, the parity check matrixes are segmented (into groups) according to a predetermined rule, and a minimum unit of the segmented parity check matrixes is referred to as a unit area. This segmentation is done such that the parity check matrixes are segmented into row groups 151 each having a predetermined row count and into column groups 152 each having a predetermined column count, and is specifically done as below. To begin with, the parity check matrix is segmented into the row groups 151 according to every Mg-rows as illustrated in FIG. 3. Each of the segmented row groups is defined as an aggregation of the check nodes that are simultaneously processed at each processing cycle in the decoding device. According to the coding specification in the first embodiment, the row group 151 is a group having 4 rows in a case where the coding rate is 1/5 and having 1 row in a case where the coding rate is 4/5.

Further, the columns within the row group 151 are segmented into column groups 152 of which the number is equivalent to the mounting count of the arithmetic units ($Nc = (Wr \times Mg)$). The number of columns of each of the segmented column groups may be arbitrarily set, and it may be sufficient that a total sum of the column counts of the respective column groups becomes a total column count (N) of the parity check matrix. Each of the rows contained in each column group 152 is defined as the unit area. Each row group 151 contains ($Mg \times (Wr \times Mg)$) unit areas.

Then, an edge allocable area, in which one bit "1" is allocated in an arbitrary position within a unit area among the plurality of unit areas in each row group 151, is determined. All other matrix elements excluding "1" in the edge allocable area are set to "0", and "0" bits are allocated in the unit areas other than the edge allocable area. An allocation layout is determined so that there exist edge allocable areas of a number equivalent to the mounting count of the arithmetic units ($Nc = (Wr \times Mg)$) within each row group 151, wherein Wr edge allocable areas exist in each row within each row group 151, and one edge allocable area exists in each column group 152.

A thus-determined segmentation pattern within the row group 151, in other words an organizing mode of the column groups 152 and an allocation mode of the edge allocable areas, is set as the same pattern throughout all the row groups. The position of the edge in the edge allocable area is, however, set arbitrarily in any row group, and a superior effect of the LDPC code is obtained by determining the pattern so that the edges (matrix elements "1") are allocated sparsely. It is to be noted that the thus-determined organizing mode of the respective column groups 152 varies in their number of rows but is the same in their number of columns within each parity check matrix. The decoding device in the first embodiment retains, in the memory or the like (not shown, corresponding to a pattern storing means according to the present invention), the coding specification shown in FIG. 2, the above-determined segmentation pattern of the respective row groups 151 and the information about the parity check matrix. The segmentation pattern is retained in such a way that, for example, a first column group is organized by a first column through a fifth column in the parity check matrix, a second column group is organized by a sixth column through an eighth column in the parity check matrix, a first edge allocable area is allocated in a first row of the first column group, a second edge allocable area is allocated in the first row of the fifth column group, and so on. The information about the parity check matrix is required to have the positions of the edge allocable areas and the edge positions therein with respect to each row block 151.

<Connection between Memories 102, 103 and Edge-by-Edge Arithmetic Units>

A connecting relationship between the respective edge-by-edge arithmetic units 110 and the memories 102, 103 will be explained with reference to FIGS. 4 and 5. FIG. 4 is a diagram showing a connecting relationship between each edge-by-edge arithmetic unit 110 and the memories 102, 103 in the case of operating at the coding rate 1/5. FIG. 5 is a diagram showing the connecting relationship between each edge-by-edge arithmetic unit 110 and the memories 102, 103 in the case of operating at the coding rate 4/5. FIGS. 4 and 5 show the parity check matrix on the left side, and show the connecting relationship between the arithmetic unit and the memories of the decoding device on the right side. Further, portions designated by letters [X], [Y], [Z], [W] in the FIGS. 4 and 5 represent the edge allocable areas in the same rows in the parity check matrix, which are specified by the same types of letters, and the edge-by-edge arithmetic units 110 corresponding to the respective edge allocable areas are likewise specified by the same types of letters.

The memories 102 and 103 store, as described above, the likelihood information of each code bit updated in the previous round and the likelihood information of each code bit updated in the round of this time. Namely, the memories 102 and 103 have only a difference in the updated round but are the same memories with respect to the arithmetic target code bit. Hence, the following description will deal with the memories 102 and 103 as a pair of memories that is referred to simply as the [memory]. The memory is constructed of at least the same number of memory cells as the number of edge-by-edge arithmetic units, i.e., the mounting count (Nc) of the arithmetic units described above. In the first embodiment, the mounting count of the arithmetic units is "12", and therefore the memory is, as illustrated in FIGS. 4 and 5, constructed of memory cells M1 through M12.

In the decoder in the first embodiment, each memory cell and each column group 152 in the parity check matrix are arranged in one-to-one correspondence. Thus, in the decoder, when starting the decoding process, a control unit (not shown in FIG. 1) etc stores, in the predetermined memory cell corresponding to each column group 152 in the parity check matrix, the likelihood information stored in the input likelihood memory 101. To be specific, the decoder, in the case of organizing the column groups in the sequence from the first column group to the twelfth column group from the left to the right in the parity check matrix, stores, in the memory cell M1, the likelihood information of a variable node (code bit) contained in the first column group, and stores, in the memory cell M2, the likelihood information of the code bit contained in the second column group. The decoder stores, in the memory cell corresponding to each column group, the likelihood information of the variable node (code bit) contained in each column group 152 in the parity check matrix. It should be noted that each parity check matrix corresponding to each coding rate is stored in a predetermined memory or the like, and the control unit (corresponding to a likelihood information storing means according to the present invention) refers to the memory and may also store the likelihood information in the memory cell. The corresponding relationship between these memory cells and pieces of likelihood information that should be stored therein, remains unchanged regardless of the coding rate because of there being no change in the organizing mode of the column groups according to every parity check matrix.

Further, in the decoder in the first embodiment, each edge-by-edge arithmetic unit 110 and each edge allocable area in the parity check matrix are arranged in one-to-one correspondence according to every processing cycle. Each edge-by-edge arithmetic unit 110 performs the arithmetic operation about the edge in the edge allocable area corresponding to this edge-by-edge arithmetic unit 110. Note that only one edge allocable area exists in each column group 152 within each row group 151, then all the row groups 151 are organized with the same pattern, and hence it follows that each edge-by-edge arithmetic unit 110 is, in other words, associated with each column group 152.

Then, the memory cell and the edge-by-edge arithmetic unit 110 are connected to each other via a physical signal line 160. This connection is, because of getting both of the memory cell and the edge-by-edge arithmetic unit corresponding to the parity check matrix described above, inevitably determined by this correspondence. Namely, each edge-by-edge arithmetic unit 110 is, with respect to the edge allocable area corresponding to this edge-by-edge arithmetic unit 110, connected via the signal line 160 to the memory cell corresponding to the column group 152 to which the edge allocable area belongs.

The decoder in the first embodiment uses the parity check matrix described above, whereby the connection between each memory cell and each edge-by-edge arithmetic unit 110 resultantly becomes, as shown in FIGS. 4 and 5, the same one-to-one connection even at any processing cycle and at any coding rate. Accordingly, the configuration has no necessity of switching over the signal line 160 each time about every processing cycle and every coding rate, and the decoding device in the first embodiment does not require a switching device between the memory and the arithmetic unit, which has hitherto been needed for the conventional decoder.

Row-by-row arithmetic units (the row-by-row check node processing units 105) are configured in a number the same as the number of the simultaneous processing rows (Mg). Each row-by-row arithmetic unit is connected to the edge-by-edge arithmetic unit corresponding to the edge allocable area allocated in the same row in the parity check matrix. The row-by-row arithmetic unit receives an arithmetic result of each edge-by-edge arithmetic unit 110, then performs the arithmetic operation of this arithmetic result on the row-by-row basis, and returns an arithmetic result of this operation again to each edge-by-edge arithmetic unit 110.

The row-by-row arithmetic unit has a different connecting destination depending on the coding rate as shown in FIGS. 4 and 5. This is because the parity check matrix differs depending on the coding rate. As a result, the connection between the row-by-row arithmetic unit and the edge-by-edge arithmetic unit is a fixed connection during the decoding process after a certain coding process but needs changing if the coding rate is changed on the occasion of executing the next post-coding process.

As described above, each edge-by-edge arithmetic unit 110 is connected to the predetermined memory cell via the signal line 160. Each edge-by-edge arithmetic unit 110 updates the likelihood information of the code bit in which the edge is allocated in the likelihood information of the respective code bits stored in the connected memory cell. The control unit etc may give an instruction to each edge-by-edge arithmetic unit 110 about the position of the should-be-updated likelihood information in the memory cell. In this case, the control unit (corresponding to also an edge-by-edge arithmetic means according to the present invention), each time the processing cycle is finished, may refer to the row group 151 corresponding to the next cycle in the parity check matrix and to the segmentation pattern of the row group, and each edge may notify each edge-by-edge arithmetic unit 110 of the position of the edge in the edge allocable area.

[Operational Example]

An operational example of the decoding device in the first embodiment will hereinafter be described with reference to FIG. 6. FIG. 6 is a flowchart showing the operational example of the decoding device in the first embodiment. The decoding device in the first embodiment retains the parity check matrixes corresponding to the plurality of coding rates. Then, in accordance with the segmentation pattern of the parity check matrix, as described above, the memory cells configuring the memories 102, and 103 of the decoding device are connected to the edge-by-edge arithmetic units 110, and the edge-by-edge arithmetic units 110 are connected to the row-by-row arithmetic units 105.

When the input likelihood memory 101 stores the likelihood information calculated in other circuits with respect to the respective code bits of the received code bit sequence, the control unit (not illustrated in FIG. 1) of the decoding device reads the parity check matrix and the segmentation pattern corresponding to the coding rate in use (should-operate coding rate) (S601). The control unit switches over the connection between the edge-by-edge arithmetic unit and the row-by-row arithmetic unit in accordance with the readout parity check matrix and the readout segmentation pattern (S602). Subsequently, the control unit, according to the readout parity check matrix and segmentation pattern, stores, in the memory cell corresponding to each column group, the likelihood information of the code bit contained in each column group (S603).

Next, the control unit initializes or updates the round count u (S604), and starts the decoding process of the round u. At this time, the control unit notifies each edge-by-edge arithmetic unit 110 of the edge position in accordance with the readout parity check matrix (S605). The notified information is recognized from the readout parity check matrix so as to specify in which column the edge in the predetermined edge allocable area is positioned, and may also be set as an offset address (= size of area storing likelihood information of (column position - 1) x 1 code bit) corresponding to this column position.

Hereafter, the edge-by-edge arithmetic unit 110 executes the edge-by-edge arithmetic operation by using its internal functional units, wherein the likelihood information corresponding to each code bit is updated (S606). At this time, the arithmetic operation corresponding to each row in the parity check matrix is executed by the row-by-row arithmetic unit (the row-by-row check node processing unit 105). The edge-by-edge arithmetic unit and the row-by-row arithmetic unit operate respectively as follows.

The anterior variable node processing unit 111-1, based on the edge position information of which the control unit notifies, reads the likelihood information $q^{(u)}_i(0)$ about the target edge from the connected memory cell of the memory 103, further reads the likelihood information $r^{(u-1)}_{ji}(0)$ of the previous round related to the target edge from the $r_{ji}$ memory 116-1, and calculates the anterior likelihood information $q^{(u)}_{ij}(0)$ used in the processes from now onward (refer to the Formula (11)). When in the first round, the likelihood information $r^{(u-1)}_{ji}(0)$ of the previous round does not exist and is therefore not read out.

The check node first processing unit 112-1, when receiving the anterior likelihood information $q^{(u)}_{ij}(0)$ from the anterior variable node processing unit 111-1, performs the arithmetic operation based on the Formulae (2), (3) and (4), thereby calculating the value shown in the Formula (9). The calculated value is transferred to the row-by-row check node processing unit 105 and to the check node second processing unit 115-1.

The row-by-row check node processing unit 105 receives the value drawn from the Formula (9) that is outputted from each of the connected edge-by-edge arithmetic units, and calculates the value shown in the Formula (10).

The check node second processing unit 115-1, when receiving the value shown in the Formula (10) from the row-by-row check node processing unit 105 and further receiving the value shown in the Formula (9) from the check node first processing unit 112-1, calculates the likelihood information $r^{(u)}_{ji}(0)$ shown in the Formula (4) with respect to the target edge. The calculated likelihood information is transferred to the $r_{ji}$ memory 116-1 and to the variable node processing unit 117-1. The likelihood information transferred to the $r_{ji}$ memory 116-1 is stored as it is in this memory.

The variable node processing unit 117-1 reads the likelihood information added up to the previous row in the parity check matrix from the connected memory cell of the memory 102, and adds, to this readout likelihood information, the likelihood information $r^{(u)}_{ji}(0)$ calculated this time by the check node second processing unit 115-1. The thus-added likelihood information is written to a predetermined location, based on the edge position information of which the control unit notifies, of the connected memory cell.

The respective processing cycles (the processes corresponding to the number of the simultaneous processing rows (Mg)) are executed for all the rows of the parity check matrix (S607; NO, looped back to S606). When completing the processes for all the rows of the parity check matrix (S607; YES), the control unit makes, based on the updated likelihood information stored in the memory 102, another circuit unit (not illustrated in FIG. 1) generate the temporary estimated bit sequence (S608). Subsequently, the control unit makes another circuit unit (not shown in FIG. 1) execute the parity check of the generated temporary estimated bit sequence (S609).

The control unit, if a result of this parity check is judged valid or if the present round count is a maximum round count (S610; YES), finishes the decoding process, and outputs the temporary estimated bit sequence. If the result of the parity check is judged invalid and if the present round count is not the maximum round count (S610; NO), the control unit updates the round count (S604), and starts the next round.

<Operation/Effect in First Embodiment>

Herein, an operation and an effect of the decoding device in the first embodiment discussed above will be explained.

In the decoding device in the first embodiment, a plurality of parity check matrixes corresponding to a plurality of coding rates is defined.

To begin with, the row weight (Wr) and the number of the simultaneous processing rows (Mg) are determined with respect to each coding rate, corresponding to the number of the edge-by-edge arithmetic units (Nc) in the decoding device. For others, a size of each parity check matrix is determined from the parity bit length (M) and a code length (N).

Next, each of the parity check matrixes is segmented into row groups 151 each having a previously determined number of simultaneous processing rows and into column groups 152 each having a predetermined number of columns. The number of columns included in each segmented column group is arbitrarily determined so that a total sum of the column counts of the respective column groups becomes a total column count (N) of the parity check matrix. The determination is, however, made so that there exist, in each row group 151, edge allocable areas of a number equivalent to a result of multiplying the row weight (Wr) by the number of the simultaneous processing rows (Mg), and so that one edge allocable area exists in each column group 152 within each row group 151. The edge allocable area has one bit "1" allocated in an arbitrary position within the unit area in the plurality of segmented unit areas.

The memory etc retains the thus-determined plural parity check matrixes and the segmentation pattern (the organizing mode of the column groups 152 and the allocation mode of the edge allocable areas).

In accordance with the thus-determined parity check matrixes and the segmentation pattern, each edge-by-edge arithmetic unit is set corresponding to each edge allocable area in the single row group 151 and performs the arithmetic operation of the edge in the corresponding edge allocable area. Similarly, the respective memory cells are set corresponding to the respective column groups 152, and, on the occasion of starting the decoding process, the likelihood information of the variable node (code bit) contained in each column group 152 is stored in the respective memory cells corresponding to the respective column groups 152. As a result, the connections between the plurality of edge-by-edge arithmetic units and the plurality of memory cells are determined based on this correspondence.

In this way, the connection between each memory cell and each edge-by-edge arithmetic unit resultantly becomes the same one-to-one connection regardless of the processing cycle or coding rate by using the parity check matrix described above.

Hence, according to the decoding device in the first embodiment, the signal line 160 actualizing the connection is not required to be switched over each time at every processing cycle and at every coding rate, and it is possible to omit the switching device between the memory and the arithmetic unit, which has hitherto been needed in the conventional decoder. This enables a scale-down of the circuit of the decoding device in the first embodiment.

Further, even in the case of executing the decoding process corresponding to any coding rate on the basis of the above-determined number of simultaneous processing rows, the arithmetic unit in the decoding device can be operated at the high efficiency, and the edge-by-edge processing can be done simultaneously for the plurality of rows, thereby making it possible to actualize the high-speed decoding process at any coding rate as well as making it feasible to handle various coding rates.

[Second Embodiment]

The decoding device in a second embodiment of the present invention will hereinafter be explained. In the decoding device in the first embodiment discussed earlier, the device configuration and the decoding processing method are determined based on a segmentation pattern with which the unit area in the parity check matrix becomes a single-row but arbitrary-number-of-columns area. The decoding device in the second embodiment uses the segmentation pattern with which the unit area is an area containing an arbitrary number of n-row/n-column square matrixes. Configurations other than the parity check matrix are basically the same as those in the first embodiment.

[Device Configuration]

An example of a circuit configuration of the decoding device in the second embodiment is the same as in the first embodiment, and hence its explanation is herein omitted (see FIG. 1).

<Parity check matrix>

The parity check matrix used in the second embodiment will hereinafter be described with reference to FIGS. 2 and 7. The decoding device in the second embodiment shall determine, as shown in FIG. 2, the coding specification in the same way as in the first embodiment. FIG. 7 is a diagram illustrating the parity check matrix used in the second embodiment.

The decoding device in the second embodiment includes edge-by-edge arithmetic units 110 of a number equivalent to at least the mounting count (Nc) of the arithmetic units, corresponding to the coding rate 1/5 and the coding rate 4/5 as shown in FIG. 2, wherein the row weight (Wr) and the number of the simultaneous processing rows (Mg) are determined with respect to each coding rate. Then, a size of each of the parity check matrixes is determined based on the parity bit length (M) and the code length (N).

In the second embodiment, the segmentation pattern of the parity check matrix is determined so that the unit area becomes the area containing the arbitrary number of n-row/n-column square matrixes. Namely, a natural number $n$ by which to divide the row count (M) and the column count (N) in each parity check matrix is defined, whereby the segmentation is done so that each row group 151 comprises (the number of simultaneous processing rows (Mg) x $n$)

rows, and each column group 152 comprises (n x arbitrary number in each column group) columns.

The edge allocable area in the unit area determined by this segmentation is determined in the same way as in the first embodiment. With this contrivance, each unit area other than the edge allocable area contains an arbitrary number of n-row/n-column zero matrixes per column group in a column-increasing direction. The edge allocable area is an area where any one of the square matrixes in the unit area becomes an edge allocation square matrix 181. The edge allocation square matrix 181 is an n-row/n-column matrix, wherein only one edge is allocated per row in an arbitrary position in each row.

The thus-determined segmentation pattern in the row group 151, i.e., the organizing mode of the column group 152 and the allocation mode of the edge allocable area, shall be the same throughout all the row groups. The position of the edge allocation square matrix 181 within the edge allocable area and the edge position in each row within the edge allocation square matrix 181 are set arbitrarily in any row group and are determined so that the edges are allocated sparsely, thereby utilizing the superior effect of the LDPC code.

In the decoding device in the second embodiment also, the memory etc retains, in the same way as in the first embodiment, the above-determined segmentation pattern and the parity check matrix in addition to the coding specification shown in FIG. 2. The decoding device in the second embodiment is capable of getting the information quantity about the parity check matrixes that should be retained in the memory less than by the decoding device in the first embodiment. The decoding device in the first embodiment has the necessity of having the position of the edge allocable area with respect to each row block 151 and the edge position in this area regarding to the parity check matrix. On the other hand, the decoding device in the second embodiment has the necessity of having the position of the edge allocable area with respect to each row block 151, the position of the edge allocation square matrix within each edge allocable area and the edge position in each edge allocation square matrix. Accordingly, the decoding device in the second embodiment has a larger information quantity due to the amount of information about the positions of the edge allocation square matrixes in the respective row blocks 151, but is smaller in total information quantity because of having a larger number of rows contained in the respective row blocks 151 in the second embodiment. This is because the unit area is configured by the square matrix.

<Connection between Memories 102, 103 and Edge-by-Edge Arithmetic Unit 110>

The connecting relationship between each edge-by-edge arithmetic unit 110 and the memories 102, 103 is the same as in the first embodiment (see FIGS. 4 and 5). Namely, each column group 152 and the predetermined memory cell are arranged in one-to-one correspondence, and each edge-by-edge arithmetic unit 110 and each edge allocable area are arranged in one-to-one correspondence per processing cycle. Then, with this one-to-one correspondence, the one-to-one connection between each memory cell and each edge-by-edge arithmetic unit 110 is established via the physical signal line 160. Accordingly, the decoding device in the second embodiment also takes a configuration having no necessity for performing the switchover at every processing cycle and at every coding rate, and it is unnecessary for the decoding device in the second embodiment to include a switching device between the memory and the arithmetic unit, which has hitherto been needed in the conventional decoder.

The configuration and the processing about the row-by-row arithmetic unit (the row-by-row check node processing unit 105) are the same as those in the first embodiment. The second embodiment is, however, different from the first embodiment in terms of a processing sequence of the rows (check nodes) in the parity check matrix that undergo the likelihood information arithmetic operation in the respective edge-by-edge arithmetic units 110. Namely, in the first embodiment, each row group 151 contains rows corresponding to the number of the simultaneous processing rows (Mg) with the result that the arithmetic operation of every row group 151 is completed at one processing cycle, however, in the second embodiment, the arithmetic operation of every row group 151 becomes a unit finished after $n$ processing cycles. The next row group 151 is set as the arithmetic operation target at a point of time (a point of time when finishing $n$ processing cycles) when finishing the arithmetic operations of the first row through the $n$-th row in the edge allocation square matrix in the edge allocable area to which each edge-by-edge arithmetic unit is allocated. Thus, the control unit, each time the processing cycle is finished, notifies of the position of the should-be-next-updated likelihood information in the memory cell to which each edge-by-edge arithmetic unit 110 is connected on the basis of pieces of information about the position of the edge allocation square matrix in the target edge allocable area and about the edge position in every row within this edge allocation square matrix, which are stored in the memory.

[Third Embodiment]

The decoding device in a third embodiment of the present invention will hereinafter be explained. In the decoding device according to the second embodiment discussed earlier, the device configuration and the decoding processing method are determined based on a segmentation pattern in which the unit area in the parity check matrix contains an arbitrary number of n-row/n-column square matrixes. The decoding device in the third embodiment uses such a segmentation pattern that the unit area becomes an area containing an arbitrary number of m-row/n-column matrixes. The configurations other than the parity check matrix are the same as those in the first embodiment and the second embodiment, and hence their explanations are omitted, wherein the discussion herein will be focused on the configuration of the parity check matrix and on the configurations of the memory and the edge-by-edge arithmetic unit that are related to the parity check matrix.

<Parity check matrix>

The parity check matrix used in the third embodiment will be explained with reference to FIGS. 2 and 8. In the decoding device in the third embodiment also, the coding specification shall be, as shown in FIG. 2, determined in the same way as in the first embodiment. FIG. 8 is a diagram illustrating the parity check matrix used in the third embodiment.

The decoding device in the third embodiment includes the edge-by-edge arithmetic units 110 of which the number is equivalent to at least the mounting count (Nc) of the arithmetic units, corresponding to the coding rate 1/5 and the coding rate 4/5 as shown in FIG. 2, wherein the row weight (Wr) and the number of the simultaneous processing rows (Mg) are determined with respect to each coding rate. Then, a size of each of the parity check matrixes is determined based on the parity bit length (M) and the code length (N).

In the third embodiment, the segmentation pattern of the parity check matrix is determined so that the unit area becomes an area containing an arbitrary number of m-row/n-column matrixes. Namely, a natural number $m$ by which to divide the row count (M) and a natural number $n$ by which to divide the column count (N) in each parity check matrix are respectively defined, whereby the segmentation is done so that each row group 151 is organized by the (the number of simultaneous processing rows (Mg) x m) rows, and each column group 152 is organized by the (n x arbitrary number in each column group) columns.

The allocating method of the edge allocable area is the same as in the first embodiment. The unit areas other than the edge allocable area contain an arbitrary number of m-row/n-column zero matrixes per column group in a column-increasing direction. The edge allocable area is an area where any one of the matrixes in the unit area becomes an edge allocation matrix 191. The edge allocation matrix 191 is an m-row/n-column matrix, wherein only one edge is allocated per row in an arbitrary position in each row.

The thus-determined segmentation pattern in the row group 151, representing the organizing mode of the column group 152 and the allocation mode of the edge allocable area, shall be the same throughout all the row groups. The position of the edge allocation matrix 191 within the edge allocable area and the edge position in each row within the edge allocation matrix 191 are set arbitrarily in any row group and are determined so that the edges are allocated sparsely, thereby effectively using the LDPC code.

In the decoding device in the third embodiment also, the memory etc retains, in the same way as in the first and second embodiments, the above-determined segmentation pattern and the parity check matrix in addition to the coding specification shown in FIG. 2. The decoding device in the third embodiment is, for the same reason as elucidated in the second embodiment, capable of reducing the information quantity about the parity check matrixes that should be retained in the memory compared to the decoding device in the first embodiment. Compared with the decoding device in the second embodiment, the information quantity increases by a size of information about the row count m because of setting the number of rows included in the unit area to the row count m, however, there is an advantage of increasing a degree of freedom in terms of determining the shape of the parity check matrix by removing the restriction that the parity check matrix be the square matrix.

<Connection between Memories 102, 103 and Edge-by-Edge Arithmetic Unit 110>

The connecting relationship between each edge-by-edge arithmetic unit 110 and the memories 102, 103 is the same as in the first and second embodiments (see FIGS. 4 and 5), and the decoding device in the third embodiment also has neither the necessity for switching over the signal line 160 at every processing cycle and at every coding rate nor the need for a switching device between the memory and the arithmetic unit, which has hitherto been needed in the conventional decoder.

The processing sequence of the rows (check nodes) in the parity check matrix that undergo the likelihood information arithmetic operation in the respective edge-by-edge arithmetic units 110, is the same as in the second embodiment. In the third embodiment, however, the row count in the unit area is set to m rows, and hence the arithmetic operation of every row group 151 is in units finished at m processing cycles. With this contrivance, the control unit, each time the processing cycle is finished, notifies of the position of the should-be-next-updated likelihood information in the memory cell to which each edge-by-edge arithmetic unit 110 is connected on the basis of pieces of information about the position of the edge allocation matrix 191 in the target edge allocable area and about the edge position in every row within this edge allocation matrix 191, which are stored in the memory.

[Fourth Embodiment]

The decoding device in a fourth embodiment of the present invention will hereinafter be described. The decoding device in the first embodiment explained earlier determines the device configuration and the decoding processing method on the basis of the segmentation pattern with which the unit area in the parity check matrix becomes the 1-row/arbitrary-number-of-column area. The decoding device in the fourth embodiment uses such a segmentation pattern that the unit area becomes an area containing an m-row/arbitrary-number-of-column matrix. Configurations excluding the parity check matrix are basically the same as in the other embodiments described above, so that their explanations are omitted, and the description shall herein be focused on the configuration of the parity check matrix and the configurations of the memory and of the edge-by-edge arithmetic unit 110 that are related to the parity check matrix.

<Parity check matrix>

The parity check matrix used in the fourth embodiment will be explained with reference to FIGS. 2 and 9. In the decoding device in the fourth embodiment also, the coding specification shall, as shown in FIG. 2, be determined in the same way as in the other embodiments. FIG. 9 is a diagram showing the parity check matrix used in the fourth embodiment.

In the fourth embodiment, the segmentation pattern of the parity check matrix is determined so that the unit area comes to have an m-row/arbitrary-number-of-column matrix. Namely, a natural number m by which to divide the row count (M) in each parity check matrix is defined, whereby the segmentation is done so that each row group 151 is organized by the (the number of simultaneous processing rows (Mg) x m) rows, and each column group 152 is organized by the arbitrary number of columns.

The allocating method of the edge allocable area is the same as in the other embodiments. The unit areas other than the edge allocable area become an m-row/arbitrary-number-of-columns zero matrix. The edge allocable area is the m-row/arbitrary-number-of-columns matrix and is also the matrix in which only one edge is allocated per row in an arbitrary position in each row.

The thus-determined segmentation pattern in the row group 151, which represents, i.e., the organizing mode of the column group 152 and the allocation mode of the edge allocable area, shall be the same throughout all the row groups. The position of the edge allocable area and the edge position in each row within the edge allocable area are set arbitrarily in any row group and are determined so that the edges are allocated sparsely to make best use of the LDPC code.

In the decoding device in the fourth embodiment also, the memory etc retains, in the same way as in the other embodiments, the above-determined segmentation pattern and the parity check matrix in addition to the coding specification shown in FIG. 2. The decoding device in the fourth embodiment is, for the same reason as in the second embodiment, capable of reducing the information quantity about the parity check matrixes that should be retained in the memory in comparison with the first embodiment. Compared to the second embodiment and the third embodiment, the information quantity increases by a size of information about the row count m and by a size of information about the row count of each column group 152 because of the unit area size being set arbitrarily, however, there is an advantage of increasing a degree of freedom in terms of freely determining the shape of the parity check matrix.

<Connection between Memories 102, 103 and Edge-by-Edge Arithmetic Unit 110>

The connecting relationship between each edge-by-edge arithmetic unit 110 and the memories 102, 103 is the same as in the other embodiments (see FIGS. 4 and 5), and the decoding device in the fourth embodiment also has neither the necessity for switching over the signal line 160 at every processing cycle and at every coding rate nor any switching device between the memory and the arithmetic unit, which has hitherto been needed in the conventional decoder.

The processing sequence of the rows (check nodes) in the parity check matrix that undergo the likelihood information arithmetic operation in the respective edge-by-edge arithmetic units 110, is the same as in the second embodiment and the third embodiment, and hence its explanation is omitted. In the fourth embodiment, however, the row count in the unit area is set to the m rows, and hence the arithmetic operation of every row group 151 becomes the unit of its being finished at m processing cycles. With this contrivance, the control unit, each time the processing cycle is finished, notifies of the position of the should-be-next-updated likelihood information in the memory cell to which each edge-by-edge arithmetic unit 110 is connected on the basis of pieces of information about the shape of the target edge allocable area and about the edge position in every row within this edge allocable area, which are stored in the memory.

[Fifth Embodiment]

The decoding device in a fifth embodiment of the present invention will hereinafter be described. In the decoding device in the fifth embodiment, the configuration of the decoding device and the processing procedure are determined by use of a virtual parity check matrix different from the actual parity check matrix that should be used for decoding.

[Device Configuration]

An example of a circuit configuration of the decoding device in the fifth embodiment will be explained with reference to FIG. 10. FIG. 10 is a block diagram illustrating the example of the circuit configuration of the decoding device in the fifth embodiment. The decoding device in the fifth embodiment includes, in addition to the configuration in the first embodiment, a memory control unit 201.
Configurations other than the memory control unit 201 are the same as those in the other embodiments, and hence herein only the memory control unit 201 will be explained.

The memory control unit 201 rearranges, based on the virtual parity check matrix used in the fifth embodiment, pieces of likelihood information of the respective code bits stored in the input likelihood memory 101 according to a predetermined rule, and stores the rearranged likelihood information in the memory 102. Further, when the control unit reads the updated likelihood information stored in the memory 102 for the temporary estimation, the memory control unit 201 rearranges the likelihood information in the original sequence of the code bits from the rearranged status.

The virtual parity check matrix may take a form of any parity check matrix in the other embodiments, and the device configuration and the processing procedure are determined corresponding to the virtual parity check matrix in the same way as in the embodiments described above. The memory control unit 201 has conversion information for conversion into the virtual parity check matrix from the parity check matrix that should be actually used for decoding, and makes the rearrangement based on this conversion information. The conversion information represents information about column replacement. Actually, the conversion involves row replacement, however, the rows (check nodes) in the parity check matrix correspond to the simple processing sequence in the decoding device according to the fifth embodiment, and therefore the information about the row replacement is unrelated to the memory control unit 201. Only the information about the column replacement may suffice for the conversion information retained in the memory control unit 201.

The columns (variable nodes) in the parity check matrix correspond to the respective code bits, and hence the memory control unit 201 derives a should-be-stored position in the memory 102 from the information on the column replacement. For instance, in the virtual parity check matrix, if the first column in the parity check matrix used for the actual decoding is replaced by a fifth column, the memory control unit 201 stores the likelihood information about the first code bit stored in the input likelihood memory 101 in an area that should store the likelihood information about the fifth code bit within the memory 102. Conversely, if the likelihood information is updated and undergoes the temporary estimation, the memory control unit 201 outputs the likelihood information extracted from the area storing the likelihood information about the fifth code bit within the memory 102, as the likelihood information about the first code bit, to the circuit unit performing the temporary estimation.

Thus, the decoding device in the fifth embodiment can handle a case in which a parity check matrix for decoding the data coded by LDPC code with sufficient error correcting capability is not realizable using the first to fourth embodiments discussed above.

**Claims**

**1.** A decoding device for decoding coded data coded by a low density parity check code in a way that uses a plurality of parity check matrixes corresponding to a plurality of coding rates and having a uniform row weight, comprising:

a pattern storing means for storing information about a parity check matrix, in the plurality of parity check matrixes, corresponding to the coding rate of the coded data and the segmentation pattern of the parity check matrix, the segmentation pattern being formed by segmenting each of the plurality of parity check matrixes into a plurality of row groups and into a plurality of column groups of which the number is the same throughout the plurality of parity check matrixes, and by allocating each of the plurality of parity check matrixes so that there is one edge allocation area, being a unit area of a plurality of segmented unit areas and having an edge, in each of the plurality of column groups within each of the plurality of row groups;
a likelihood information storing means for dividing likelihood information of respective code bits of the coded data into each memory cell with respect to each of the plurality of column groups based on the stored segmentation pattern and storing the divided likelihood information; and

a plurality of edge-by-edge arithmetic means each connected, corresponding to any one of the edge allocation areas, to the memory cell storing the likelihood information about the column group to which the corresponding edge allocation area belongs, and for updating the likelihood information of the code bit corresponding to an edge within the corresponding edge allocation area based on the likelihood information stored in the connected memory cell.

2. A decoding device according to claim 1, wherein said pattern storing means are arranged to store a position of the edge allocation area and a position of the edge within the edge allocation area, as information about the parity check matrix, and

each of said plurality of edge-by-edge arithmetic means is arranged to determine an address of the should-be-updated likelihood information within the connected memory cell based on the stored position of the edge with respect to the corresponding edge allocation area of processing target.

3. A decoding device according to claim 1 or 2, wherein each of the plurality of row groups is an aggregation of rows for performing a decoding process at one processing cycle, and

said plurality of edge-by-edge arithmetic means are provided in a number corresponding to at least a numerical value obtained by multiplying the number of the rows performed the decoding process at one processing cycle by the row weight of the parity check matrix, for updating the likelihood information for one row group at one processing cycle.

4. A decoding device according to claim 1, wherein each of the plurality of parity check matrixes and the segmentation pattern are allocated such that each of the plurality of segmented unit areas is formed of at least one matrix, any one of the matrixes contained in the edge allocation area becomes an edge allocation matrix where the edge is allocated, and other matrixes become zero matrixes,

said pattern storing means being arranged to store, as the information about the parity check matrix, a position of the edge allocation area, a position of the edge allocation matrix in the edge allocation area and a position of the edge within the edge allocation matrix, and

each of said plurality of edge-by-edge arithmetic means being arranged to determine the address of the should-be-updated likelihood information within the connected memory cell based on the position of the edge allocation matrix related to the corresponding edge allocation area of processing target and the position of the edge within the edge allocation matrix.

5. A decoding device according to claim 4, wherein the matrix contained in each of the plurality of segmented unit areas is a square matrix.

6. A decoding device according to claim 1, wherein each of the plurality of segmented unit areas is one matrix, and an edge is allocated in the respective rows in the edge allocation area,

said pattern storing means being arranged to store, as information about the parity check matrix, a position of the edge allocation area, a shape of the matrix in the edge allocation area, and a position of the edge within the edge allocation area, and

each of said plurality of edge-by-edge arithmetic means being arranged to determine the address of the should-be-updated likelihood information within the connected memory cell based on the shape of the matrix in the edge allocation area related to the corresponding edge allocation area of processing target and the position of the edge in the edge allocation area.

7. A decoding device according to any one of claims 1 to 6, wherein each of the plurality of parity check matrixes is a parity check matrix in which to rearrange the columns and/or the rows of the real parity check matrix corresponding to the coded data, and

said likelihood information storing means is for rearranging, based on rearrangement information from the real parity check matrix into the stored parity check matrix, the likelihood information of the respective code bits of the coded data in accordance with the stored parity check matrix, thereafter for dividing the likelihood information into each memory cell with respect to each of the plurality of column groups based on the stored segmentation pattern, and storing the divided likelihood information.

8. A decoding method of decoding coded data coded by a low density parity check code in a way that uses a plurality of parity check matrixes corresponding to a plurality of coding rates and having a uniform row weight, comprising:

a pattern storing step of storing information about a parity check matrix, in the plurality of parity check matrixes, corresponding to the coding rate of the coded data and the segmentation pattern of the parity check matrix, the segmentation pattern being formed by segmenting each of the plurality of parity check matrixes into a plurality of row groups and into a plurality of column groups of which the number is the same throughout the plurality of parity check matrixes, and by allocating each of the plurality of parity check matrixes so that there is one edge allocation area, being a unit area of a plurality of segmented unit areas and having an edge, in each of the plurality of column groups within each of the plurality of row groups;

a likelihood information storing step of dividing likelihood information of respective code bits of the coded data into each memory cell with respect to each of the plurality of column groups based on the stored segmentation pattern and storing the divided likelihood information; and

a edge-by-edge arithmetic step of accessing, corresponding to any one of the edge allocation areas, the memory cell storing the likelihood information about the column group to which the corresponding edge allocation area belongs, and updating the likelihood information of the code bit corresponding to an edge within the corresponding edge allocation area based on the likelihood information stored in the memory cell.

## FIG. 1

EDGE-BY-EDGE ARITHMETIC UNIT — 110-1

CHECK NODE SECOND PROCESSING UNIT — 115-1

VARIABLE NODE PROCESSING UNIT — 117-1

MEMORY — 116-1

ROW-BY-ROW CHECK NODE PROCESSING UNIT — 105

CHECK NODE FIRST PROCESSING UNIT — 112-1

ANTERIOR VARIABLE NODE PROCESSING UNIT — 111-1

MEMORY — 102

INPUT LIKELIHOOD

INPUT LIKELIHOOD MEMORY — 101

DECODED RESULT

MEMORY — 103

EDGE-BY-EDGE ARITHMETIC UNIT — 110-2

EDGE-BY-EDGE ARITHMETIC UNIT — 110-Nc

EP 1 819 055 A1

# FIG. 2

| CODING RATE | ROW WEIGHT | THE NUMBER OF SIMULTANEOUS PROCESSING ROWS | CODE LENGTH | INFORMATION LENGTH | PARITY BIT LENGTH |
|---|---|---|---|---|---|
| R | wr | Mg | N | K | M |
| 1/5 | 3 | 4 | 5,000 | 1,000 | 4,000 |
| 4/5 | 12 | 1 | 5,000 | 4,000 | 1,000 |

# FIG. 3

CODEWORD (N BITS)

Mg
Mg

CHECK SYMBOL
(M BITS)

Mg

: EDGE ALLOCABLE AREA

0···0 : ONLY "0" IS
ALLOCATED

THE ARBITRARY
NUMBER OF COLUMNS

153

UNIT
AREA

ONE
ROW

N BITS

| | 0···0 | 0···0 | 0···0 | | 0···0 | | | 0···0 | 0···0 | 0···0 | 0···0 | 0···0 |
| 0···0 | | 0···0 | 0···0 | 0···0 | 0···0 | 0···0 | | 0···0 | 0···0 | | 0···0 |
| 0···0 | 0···0 | | 0···0 | 0···0 | 0···0 | 0···0 | 0···0 | 0···0 | | 0···0 | |
| 0···0 | 0···0 | 0···0 | | 0···0 | | 0···0 | 0···0 | | 0···0 | 0···0 | 0···0 |

Mg

152

151

EP 1 819 055 A1

# FIG. 4

FIRST CYCLE (PROCESSING OF FIRST TO FOURTH ROWS)

105 → ROW-BY-ROW BASIS

110 → EDGE-BY-EDGE BASIS

X X X Y Y Y Z Z Z W W W

160 →

102, 103

M1 M2 M3 M4 M5 M6 M7 M8 M9 M10 M11 M12

SECOND CYCLE (PROCESSING OF FIFTH TO EIGHTH ROWS)

105 → ROW-BY-ROW BASIS

110 → EDGE-BY-EDGE BASIS

X X X Y Y Y Z Z Z W W W

160 →

102, 103

M1 M2 M3 M4 M5 M6 M7 M8 M9 M10 M11 M12

N BITS

M BITS

FIG. 5

# FIG. 6

START

READ PARITY CHECK MATRIX AND SEGMENTATION PATTERN OF CORRESPONDING CODING RATE ⌐S601

SWITCH OVER CONNECTION BETWEEN ROW-BY-ROW ARITHMETIC UNIT AND EDGE-BY-EDGE ARITHMETIC UNIT CORRESPONDING TO PARITY CHECK MATRIX ⌐S602

STORE LIKELIHOOD INFORMATION OF RECEIVED CODE BIT SEQUENCE IN MEMORY CELLS M1-M12 ⌐S603

UPDATE ROUND COUNT ⌐S604

NOTIFY EDGE-BY-EDGE ARITHMETIC UNIT OF EDGE POSITION ⌐S605

S606 ⌐ EXECUTE EDGE-BY-EDGE ARITHMETIC OPERATION FOR THE NUMBER OF SIMULTANEOUS PROCESSING ROWS (LIKELIHOOD INFORMATION OF CODE BIT IS UPDATED)

S607 ⌐ ARITHMETIC OPERATIONS FOR ALL ROWS (M) FINISHED?   NO

YES

GENERATE TEMPORARY ESTIMATED BIT SEQUENCE BASED ON UPDATED LIKELIHOOD INFORMATION ⌐S608

PERFORM PARITY CHECK BASED ON TEMPORARY ESTIMATED BIT SEQUENCE ⌐S609

S610 ⌐ PARITY CHECK OK? OR MAXIMUM ROUND FINISHED?   NO

YES

END

# FIG. 7

CODEWORD (N BITS)

Mg x n

Mg x n

CHECK SYMBOL (M BITS)

Mg x n

N BITS

153 (n x ARBITRARY NUMBER) COLUMNS

n-COLUMNS

n-ROWS

Mg x n

152  151

: EDGE ALLOCABLE AREA

0-0    ...    0-0
           181

0...0  : ARBITRARY NUMBER OF (n x n) 0-MATRIXES ARE CONTAINED

EP 1 819 055 A1

# FIG. 8

CODEWORD (N BITS)

CHECK SYMBOL (M BITS)

Mg × m

Mg × m

Mg × m

:EDGE ALLOCABLE AREA

0-0 ... 0-0

191

0...0 :ARBITRARY NUMBER OF (m × n) 0-MATRIXES ARE CONTAINED

(n × k) COLUMNS

153

n-COLUMNS

m-ROWS

Mg × m

N BITS

152   151

FIG. 9

CODEWORD (N BITS)

CHECK SYMBOL
(M BITS)

Mg x m

Mg x m

Mg x m

: EDGE ALLOCABLE AREA

0···0 : (m x ARBITRARY NUMBER OF COLUMNS) 0-MATRIXES

ARBITRARY NUMBER OF COLUMNS

153

m-ROWS

N BITS

Mg x m

152

151

EP 1 819 055 A1

## FIG. 10

EP 1 819 055 A1

# FIG. 11

CODEWORD (N BITS)

CHECK SYMBOL
(M BITS)

※BLANK REPRESENTS ELEMENT "0"

# FIG. 12

N BITS

M BITS

```
1    1                          1
     1              1       1
     1     1                     1
     1                  1   1
1           1                   1
1                         1 1
1    1                          1
     1    1                    1
```

BLOCK 1    BLOCK 2    BLOCK 3

CIRCUIT CONFIGURATION

ARITHMETIC UNIT ◄---- ROW-BY-ROW BASIS

11

EDGE-BY-EDGE BASIS

ARITHMETIC UNIT    ARITHMETIC UNIT    ARITHMETIC UNIT ◄----

21    22    23

MEMORY    MEMORY    MEMORY

31    32    33

N BITS

EP 1 819 055 A1

# FIG. 13

| CODING RATE | ROW WEIGHT | CODE LENGTH | INFORMATION LENGTH | PARITY BIT LENGTH |
|---|---|---|---|---|
| R | wr | N | K | M |
| 1/5 | 3 | 5, 000 | 1, 000 | 4, 000 |
| 4/5 | 10 | 5, 000 | 4, 000 | 1, 000 |

## FIG. 14

FIRST CYCLE (PROCESSING OF FIRST TO FOURTH ROWS)

TE1  TE2  TE3  TE4

E1 E2 E3 E4 E5 E6 E7 E8 E9 E10 E11 E12

M1 M2 M3 M4 M5 M6 M7 M8 M9 M10 M11 M12

SECOND CYCLE (PROCESSING OF FIFTH TO EIGHTH ROWS)

TE1  TE2  TE3  TE4

E1 E2 E3 E4 E5 E6 E7 E8 E9 E10 E11 E12

M1 M2 M3 M4 M5 M6 M7 M8 M9 M10 M11 M12

N BITS

M BITS

B1 B2 B3 B4 B5 B6 B7 B8 B9 B10 B11 B12

FIG. 15

FIRST CYCLE (PROCESSING OF FIRST TO FOURTH ROWS)

TE1

E1 E2 E3 E4 E5 E6 E7 E8 E9 E10 E11 E12

M1 M2 M3 M4 M5 M6 M7 M8 M9 M10 M11 M12

SECOND CYCLE (PROCESSING OF FIFTH TO EIGHTH ROWS)

TE1

E1 E2 E3 E4 E5 E6 E7 E8 E9 E10 E11 E12

M1 M2 M3 M4 M5 M6 M7 M8 M9 M10 M11 M12

N BITS

M BITS

B1 B2 B3 B4 B5 B6 B7 B8 B9 B10 B11 B12

FIG. 16

SWITCHING BASED ON CODING RATE

SWITCHING PER CYCLE

**European Patent Office**

**EUROPEAN SEARCH REPORT**

Application Number

EP 07 10 1974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2006/001015 A (RUNCOM TECHNOLOGIES LTD [IL]; SHASHA ELI [IL]) 5 January 2006 (2006-01-05) * page 4 - page 11; figure 7 * ----- | 1-8 | INV. H03M13/11 |
| A | EP 1 610 466 A (INFINEON TECHNOLOGIES AG [DE]) 28 December 2005 (2005-12-28) * paragraphs [0107], [0114], [0115], [0126]; figures 17,21,23 * ----- | 1-8 | |
| A | ROVINI M ET AL: "VLSI Design of a High-Throughput Multi-Rate Decoder for Structured LDPC Codes" PROC., IEEE EUROMICRO CONFERENCE ON DIGITAL SYSTEM DESIGN, PORTO, PORTUGAL, 30 August 2005 (2005-08-30), - 3 September 2005 (2005-09-03) pages 202-209, XP010864680 ISBN: 0-7695-2433-8 * page 203 - page 205 * * page 207, left-hand column * ----- | 1-8 | |
| | | | TECHNICAL FIELDS SEARCHED (IPC) |
| A | SHASHA E ET AL: "Multi-Rate LDPC code for OFDMA PHY" INTERNET CITATION, [Online] 27 June 2004 (2004-06-27), XP002334837 Retrieved from the Internet: URL:http://www.ieee802.org/16/tge/contrib/ C80216e-04_185.pdf> [retrieved on 2005-07-05] * page 1 - page 4 * ----- -/-- | 1-8 | H03M |

The present search report has been drawn up for all claims

| Place of search | Date of completion of the search | Examiner |
|---|---|---|
| Munich | 8 May 2007 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

&: member of the same patent family, corresponding document

EPO FORM 1503 03.82 (P04C01)

**EP 1 819 055 A1**

## EUROPEAN SEARCH REPORT

**European Patent Office**

**Application Number**

EP 07 10 1974

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | EROZ M ET AL: "Structured Low-Density Parity-Check Code Design for Next Generation Digital Video Broadcast" PROC., IEEE CONFERENCE ON MILITARY COMMUNICATIONS, MILCOM 2005, ATLANTIC CITY, NJ, USA, 17 October 2005 (2005-10-17), - 20 October 2005 (2005-10-20) pages 1-6, XP010901536 ISBN: 0-7803-9393-7 * the whole document * | 1-8 | |
| A | VILA CASADO A I ET AL: "Multiple rate low-density parity-check codes with constant blocklength" PROC., IEEE ASIMOLAR CONFERENCE ON SIGNALS, SYSTEMS AND COMPUTERS, PACIFIC GROVE, CA, USA, 7 November 2004 (2004-11-07), - 10 November 2004 (2004-11-10) pages 2010-2014, XP010781157 ISBN: 0-7803-8622-1 * the whole document * | 1-8 | |
| A | SHIMIZU K ET AL: "Partially-Parallel LDPC Decoder Based on High-Efficiency Message-Passing Algorithm" PROC., IEEE INTERNATIONAL CONFERENCE ON COMPUTER DESIGN, SAN JOSE, CA, USA, 2 October 2005 (2005-10-02), - 5 October 2005 (2005-10-05) pages 503-510, XP010846468 ISBN: 0-7695-2451-6 * the whole document * | 1-8 | |

**TECHNICAL FIELDS SEARCHED (IPC)**

-/--

The present search report has been drawn up for all claims

| Place of search | Date of completion of the search | Examiner |
|---|---|---|
| Munich | 8 May 2007 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

37

**European Patent Office**

**EUROPEAN SEARCH REPORT**

Application Number

EP 07 10 1974

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LEI YANG ET AL: "An FPGA implementation of low-density parity-check code decoder with multi-rate capability" PROC., IEEE ASIA AND SOUTH PACIFIC AUTOMATION CONFERENCE, ASP-DAC 2005, SHANGHAI, CHINA, 18 January 2005 (2005-01-18), - 21 January 2005 (2005-01-21) pages 760-763, XP010814461 ISBN: 0-7803-8736-8 * page 761 - page 763 * | 1-8 | |

-----

TECHNICAL FIELDS SEARCHED (IPC)

The present search report has been drawn up for all claims

| Place of search | Date of completion of the search | Examiner |
|---|---|---|
| Munich | 8 May 2007 | Offer, Elke |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 10 1974

This annex lists the patent family members relating to the patent documents cited in the above-mentioned European search report.
The members are as contained in the European Patent Office EDP file on
The European Patent Office is in no way liable for these particulars which are merely given for the purpose of information.

08-05-2007

| Patent document cited in search report | | Publication date | Patent family member(s) | | Publication date |
|---|---|---|---|---|---|
| WO 2006001015 | A | 05-01-2006 | NONE | | |
| EP 1610466 | A | 28-12-2005 | US | 2005283707 A1 | 22-12-2005 |

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- An Introduction to LDPC Codes. **WILLIAM E. RYAN.** Department of Electrical and Computer Engineering. The University of Arizona, 19 August 2003